(19) Europäisches Patentamt / European Patent Office / Office européen des brevets

(11) **EP 3 948 311 B1**

(12) **EUROPÄISCHE PATENTSCHRIFT**

(45) Veröffentlichungstag und Bekanntmachung des Hinweises auf die Patenterteilung:
**15.11.2023  Patentblatt 2023/46**

(21) Anmeldenummer: **20712310.0**

(22) Anmeldetag: **17.03.2020**

(51) Internationale Patentklassifikation (IPC):
**G01R 19/02** $^{(2006.01)}$    **H02H 3/24** $^{(2006.01)}$

(52) Gemeinsame Patentklassifikation (CPC):
**G01R 19/02;** G01R 19/16547; G01R 19/175

(86) Internationale Anmeldenummer:
**PCT/EP2020/057260**

(87) Internationale Veröffentlichungsnummer:
**WO 2020/193282 (01.10.2020 Gazette 2020/40)**

(54) **SCHALTUNGSANORDNUNG UND VERFAHREN ZUR ÜBERWACHUNG EINES WECHSELSPANNUNGSFÖRMIGEN SIGNALS**

CIRCUIT ARRANGEMENT AND METHOD FOR MONITORING A SIGNAL FORMED BY ALTERNATING VOLTAGE

CIRCUIT ET PROCÉDÉ DE SURVEILLANCE D'UN SIGNAL DE TENSION ALTERNATIVE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **25.03.2019  DE 102019107641**

(43) Veröffentlichungstag der Anmeldung:
**09.02.2022  Patentblatt 2022/06**

(73) Patentinhaber: **Eaton Intelligent Power Limited Dublin 4 (IE)**

(72) Erfinder: **CULCA, Horea**
**53797 Lohmar (DE)**

(74) Vertreter: **Epping - Hermann - Fischer Patentanwaltsgesellschaft mbH Schloßschmidstraße 5 80639 München (DE)**

(56) Entgegenhaltungen:
**DE-A1-102007 011 121    DE-A1-102017 116 534
US-A- 3 611 162    US-B1- 6 255 864**

**Beschreibung**

Die vorliegende Erfindung betrifft eine Schaltungsanordnung und ein Verfahren zur Überwachung eines wechselspannungsförmigen Signals.

Elektronische Geräte wie speicherprogrammierbare Steuerungen oder programmierbare Logikrelais werden einer Reihe von EMV-Prüfungen unterzogen (EMV ist die Abkürzung für elektromagnetische Verträglichkeit, englisch electromagnetic compatibility, abgekürzt EMC), wie in Produktnormen oder in den EMV-Fachgrundnormen, EN 61000-6-1..4 gefordert. Um diese Prüfungen fehlerfrei bzw. mit akzeptablen Abweichungen zu bestehen, sind in der Regel unterschiedliche EntstörMaßnahmen sinnvoll, meist elektrische Filter aber auch Filterverfahren in der Geräte-Firmware.

Meistens sind die Störungen hochfrequent und lassen sich mit Filtern in höherem Frequenzbereich dämpfen, was zu keinen inakzeptablen Signalverzögerungen z.B. für Geräteeingänge der oben genannten Klasse führt. Eine Ausnahme dazu bildet die Stoßspannung (englisch surge). Es geht um energiereiche Überspannungsimpulse, die von Schalthandlungen oder Blitze im Versorgungsnetz erzeugt werden. Diese haben nicht nur ein zerstörerisches Potential, sondern können auch den Zustand eines Eingangs unerlaubt verfälschen. In der Industrieumgebung ist die Höhe der Stoßspannung für Geräteeingänge 1.000 V, sogar demnächst bis zu 2.000 V (EN 61000-6-2 Normen-Update). Die Impulsform (nach der Grundnorm EN 61000-4-5) ist quasi dreieckig mit einer steilen Einstiegszeit (Stirnzeit) von 1,2 µs und einer Dauer von 50 ps, was aber eine "Halbier-Zeit" bezeichnet, in der die Spannung die Hälfte der Amplitude erreicht. Die Spannung sinkt dann weiter, bis sie bei ca. 100 µs den Wert 0 V erreicht; eine Überschwingung in die umgekehrte Polarität bis 30 % der Amplitude kann auch folgen. Weitere Schwingungen in Geräte-internen Schaltkreisen sind möglich, so dass man in der Praxis mit einer Dauer der Störung von mehreren Hundert Mikrosekunden rechnen kann. Um diese Störung effizient zu beseitigen, können z.B. relativ niederfrequente Filter mit einer Zeitkonstante im Bereich von mehreren Hundert Mikrosekunden bis zu einer Millisekunde verwendet werden. Für schnelle Eingänge wäre die dadurch entstehende Verzögerung zu hoch.

Dokumente EP 0935758 B1 und DE 102017116534 A1 beschreiben verschiedene Schaltungsanordnungen.

Dokument US 3 611 162 A befasst sich mit einer Anordnung zur Detektion nicht normaler Zustände von Wechselspannungsquellen. Die Anordnung umfasst eine erste und eine zweite Schmitt-Trigger Schaltung, die auf zwei Werte einer gleichgerichteten Spannung einer Quellenspannung reagieren, eine erste und eine zweite nachgeschaltete monostabile Schaltung, ein Flip-Flop und ein Logik-Gatter. Die erste monostabile Schaltung ist ausgangsseitig mit einem Rücksetzeingang des Flip-Flops und die zweite monostabile Schaltung ist ausgangsseitig mit einem Eingang des Logik-Gatters verbunden.

Dokument US 6 255 864 B1 erläutert eine Schaltungsanordnung zur Überwachung eines definierten Amplitudenschwellenwertes wechselspannungsförmiger Eingangssignale. Die Schaltungsanordnung umfasst eine Serienschaltung mit einem Gleichrichter, einem Tiefsetzer und einem Komparator sowie einen Nulldurchgangsdetektor, eine dem Nulldurchgangsdetektor nachgeschaltete Verzögerungsstufe und ein Flip-Flop. Ein Komparatorausgang und ein Ausgang der Verzögerungsstufe sind mit Eingängen des Flip-Flops verbunden derart, dass ein zustandsunterscheidendes Signal am Ausgang des Flip-Flops erzeugt wird.

Es ist Aufgabe der Erfindung, eine Schaltungsanordnung sowie ein Verfahren zur Überwachung eines wechselspannungsförmigen Signals anzugeben, mit denen der Einfluss einer Störung verringert werden kann.

Die Aufgabe wird mit den Gegenständen der unabhängigen Patentansprüche gelöst. Weiterbildungen und Ausgestaltungen sind jeweils Gegenstand der abhängigen Ansprüche.

Eine Ausführungsform einer Schaltungsanordnung zur Überwachung eines wechselspannungsförmigen Signals gemäß der Erfindung wird im unabhängigen Anspruch 1 definiert.

Mit Vorteil wird das Komparatorsignal an zwei bestimmten Zeitpunkten abgetastet. Liegt eine Störung vor, so weist das Komparatorsignal unterschiedliche Werte auf. Dies wird durch den zweiten Wert des ersten Verarbeitungssignals signalisiert. In diesem Fall kann die Logikschaltung z.B. die unterschiedlichen Werte des Komparatorsignals ignorieren.

In einer Ausführungsform generiert die Logikschaltung beim zweiten Wert des ersten Verarbeitungssignals ein erstes Ausgangssignal, das den Wert des an den zwei bestimmten Zeitpunkten abgetasteten Wert des Komparatorsignals hat, und behält beim ersten Wert des ersten Verarbeitungssignals den vorhergehenden Wert des ersten Ausgangssignals bei.

In einer Ausführungsform kann im Fall einer einphasigen Schaltungsanordnung das erste Ausgangssignal als ein Wechselspannungszustandssignal verwendet werden.

In einer Ausführungsform liegen die zwei bestimmten Zeitpunkte der mindestens zwei vorgegebenen Zeitpunkte in genau einer Periode des zu überwachenden wechselspannungsförmigen Signals. Das Verfahren wird wiederholt, z.B. in der nächsten, übernächsten oder n-ten Periode.

In einer alternativen Ausführungsform liegt der erste Zeitpunkt der zwei bestimmten Zeitpunkte in einer ersten Periode und der zweite Zeitpunkt der zwei bestimmten Zeitpunkte in einer zweite Periode des zu überwachenden wechselspannungsförmigen Signals.

In einer Ausführungsform sind die zwei bestimmten Zeitpunkte der mindestens zwei vorgegebenen Zeitpunkte derart gewählt, dass sie bei folgenden Werten liegen:

$$T/4 - \Delta t \text{ und } T/4 + \Delta t,$$

wobei T eine Periodendauer des zu überwachenden wechselspannungsförmigen Signals und $\Delta t$ eine Zeitdauer kleiner T/4 ist. Ein sinusförmiges Signal (mit dem Wert 0 bei t=0 und der Periodendauer T) hat bei den zwei bestimmten Zeitpunkten T/4 - $\Delta t$ und T/4 + $\Delta t$ denselben Wert. Beispielsweise ist $\Delta t$ = T/8 und sind somit die zwei bestimmte Zeitpunkte T/8 und T·3/8. Mit Vorteil entspricht bei den zwei bestimmten Zeitpunkten T/8 und T·3/8 der Wert des sinusförmigen Signals dem Effektivwert des sinusförmigen Signals.

In einer Ausführungsform generiert die Logikschaltung ein zweites Verarbeitungssignal mit einem ersten Wert, wenn an zwei weiteren bestimmten Zeitpunkten der mindestens zwei vorgegebenen Zeitpunkte das Komparatorsignal unterschiedliche Werte aufweist, und mit einem zweiten Wert, wenn an den zwei weiteren bestimmten Zeitpunkten das Komparatorsignal denselben Wert aufweist.

In einer Ausführungsform liegen die zwei bestimmten Zeitpunkte und die zwei weiteren bestimmten Zeitpunkte der mindestens zwei vorgegebenen Zeitpunkte in derselben Periode des zu überwachenden wechselspannungsförmigen Signals. Die vier bestimmten Werte können voneinander verschieden sein.

In einer Ausführungsform sind die zwei weiteren bestimmten Zeitpunkte der mindestens zwei vorgegebenen Zeitpunkte derart gewählt, dass sie bei folgenden Werten liegen:

$$T·7/12 - \Delta t \text{ und } T·7/12 + \Delta t.$$

In einer Ausführungsform generiert die Logikschaltung ein drittes Verarbeitungssignal mit einem ersten Wert, wenn an zwei zusätzlichen bestimmten Zeitpunkten der mindestens zwei vorgegebenen Zeitpunkte das Komparatorsignal unterschiedliche Werte aufweist, und mit einem zweiten Wert, wenn an den zwei zusätzlichen bestimmten Zeitpunkten das Komparatorsignal denselben Wert aufweist.

In einer Ausführungsform liegen die zwei zusätzlichen bestimmten Zeitpunkten, die zwei weiteren bestimmten Zeitpunkte und die zwei bestimmten Zeitpunkte der mindestens zwei vorgegebenen Zeitpunkte in derselben Periode oder in zwei aufeinanderfolgen Perioden des zu überwachenden wechselspannungsförmigen Signals. Die sechs bestimmten Werte können voneinander verschieden sein.

In einer Ausführungsform sind die zwei zusätzlichen bestimmten Zeitpunkte der mindestens zwei vorgegebenen Zeitpunkte derart gewählt, dass sie bei folgenden Werten liegen:

$$T·11/12 - \Delta t \text{ und } T·11/12 + \Delta t$$

oder

$$\Delta t - T/12 \text{ und } T·11/12 - \Delta t.$$

Das erste, zweite und dritte Verarbeitungssignal wird bei einem identischen Wert der Zeitdauer $\Delta t$ bestimmt.

In einer Ausführungsform generiert die Logikschaltung beim zweiten Wert des zweiten Verarbeitungssignals ein zweiten Ausgangssignal, das den Wert des an den zwei weiteren bestimmten Zeitpunkten abgetasteten Wert des Komparatorsignals hat, und behält beim ersten Wert des zweiten Verarbeitungssignals den vorhergehenden Wert des zweiten Ausgangssignals bei.

In einer Ausführungsform generiert die Logikschaltung beim zweiten Wert des dritten Verarbeitungssignals ein drittes Ausgangssignal, das den Wert des an den zwei zusätzlichen bestimmten Zeitpunkten abgetasteten Wert des Komparatorsignals hat, und behält beim ersten Wert des dritten Verarbeitungssignals den vorhergehenden Wert des dritten Ausgangssignals bei.

In einer Ausführungsform generiert die Logikschaltung das Wechselspannungszustandssignal durch ODER-Verknüpfung des ersten, zweiten und dritten Ausgangssignals.

In einer Ausführungsform ist die Logikschaltung als Mikrocontroller oder Mikroprozessor realisiert.

In einer Ausführungsform umfasst die Logikschaltung ein dem Nulldurchgangsdetektor nachgeschaltetes erstes Zeitglied zur Erzeugung eines ersten Taktsignals in Abhängigkeit vom Detektorsignal, ein dem Nulldurchgangsdetektor nachgeschaltetes zweites Zeitglied zur Erzeugung eines zweiten Taktsignals in Abhängigkeit vom Detektorsignal oder in Abhängigkeit vom ersten Taktsignal, ein erstes und ein zweites Flip-Flop und ein Exklusiv-Oder-Gatter.

Ein Ausgang des Komparators kann mit einem Dateneingang des ersten Flip-Flops und des zweiten Flip-Flops gekoppelt sein. Ein Ausgang des ersten Zeitglieds kann mit einem Takteingang des ersten Flip-Flops gekoppelt sein. Ein Ausgang des zweiten Zeitglieds kann mit einem Takteingang des zweiten Flip-Flops gekoppelt sein. Ein Ausgang des ersten Flip-Flops und ein Ausgang des zweiten Flip-Flops können mit Eingängen des Exklusiv-Oder-Gatters gekoppelt sein. Das Exklusiv-Oder-Gatter generiert das erste Verarbeitungssignal.

In einer Ausführungsform ist das zweite Zeitglied dem ersten Zeitglied nachgeschaltet und wird durch das erste Taktsignal zur Erzeugung des zweiten Taktsignals getriggert.

In einer Ausführungsform umfasst die Logikschaltung einen Multiplexer. Der Multiplexer umfasst einen ersten Eingang, der mit dem Ausgang des ersten oder des zweiten Flip-Flops gekoppelt ist, einen zweiten Eingang, einen Steuereingang, der mit einem Ausgang des Exklusiv-Oder-Gatters gekoppelt ist, und einen Ausgang, der mit dem zweiten Eingang gekoppelt ist und an dem das erste Ausgangssignal abgegeben wird.

In einer Ausführungsform sind der Multiplexer, das Exklusiv-Oder-Gatter, die Flip-Flops und/oder die Zeitglieder durch Software innerhalb eines Mikrocontrollers oder Mikroprozessors realisiert.

Eine Ausführungsform eines Verfahrens zur Überwachung eines wechselspannungsförmigen Signals gemäß der Erfindung wird im unabhängigen Anspruch 10 definiert.

In einer Ausführungsform ist das Referenzsignal wechselspannungsförmig. Das Referenzsignal und das wechselspannungsförmige Signal sind frequenzgleich. Das Referenzsignal kann sinusförmig sein. Das wechselspannungsförmige Signal kann sinusförmig sein.

In einer Ausführungsform sind die Schaltungsanordnung und das Verfahren zur Überwachung und Entstörung sinusförmiger Wechselspannungssignale implementiert.

Das Verfahren zur Überwachung eines wechselspannungsförmigen Signals kann z.B. durch die Schaltungsanordnung nach einer der oben definierten Ausführungsformen und mit den oben beschriebenen Schritten realisiert werden.

In einer Ausführungsform kann für eine DC-Versorgung und DC-Signale das oben erläuterte Verfahren über einen Schalter umgangen werden. An einem Ausgang der Schaltungsanordnung wird direkt das Komparatorsignal abgegeben.

In einer Ausführungsform sind durch die Kombination von AC/DC-Geräten in einem Gerät die Eingänge auch für den AC-Betrieb schnell. Die oben beschriebene Schaltungsanordnung und das Verfahren vermeiden Probleme bei der Surge-Prüfung (Verfälschung der Eingänge). Durch dieses Verfahren kann die Störung in der Firmware unter Berücksichtigung/Anpassung von verschiedenen AC-Erfassungsverfahren gefiltert werden. Das Verfahren dient zur Entstörung der AC-Eingänge, so dass die Geräte eine Surge-Prüfung bestehen.

In einer Ausführungsform kann die Überwachung und Entstörung für Geräte mit DC-Versorgung und DC-Eingängen, z.B. 24V DC in der Firmware realisiert werden. Da diese Störungsart ein einmaliges Ereignis ist, d.h. ein zweiter Störimpuls erst nach einer längeren Zeit kommt, erfasst man den Eingang zwei Mal in Abstand von z.B. 1 ms. Diese Werte werden miteinander verglichen und bei Nichtübereinstimmung ignoriert, der vorherige Wert wird beibehalten. Da die Störung nur eine der zwei Erfassungen verfälschen kann, wird die Störung dadurch eliminiert. Diese Art von Entstörung ist besonders sinnvoll, wenn die gleichen Eingänge sowohl als schnelle Eingänge als auch als Standardeingänge verwendet werden können, so dass keine Hardware-Filterung möglich ist. Als schnelle Eingänge werden sie durch andere Maßnahmen gegen Störungen geschützt, z.B. durch Anwendung von kürzeren, abgeschirmten Leitungen und in der Firmware nicht entstört.

In einer Ausführungsform kann bei AC-Geräten, die über relativ schnelle AC-Eingänge verfügen, eine derartige Verzögerung auch zu einer bedeutenden Verzerrung des Signals führen, was eine gewisse Verfälschung des Eingangs-Umschaltpegels zur Folge haben würde, die aber in der Regel noch akzeptabel ist. Moderne universelle Geräte jedoch, die sowohl mit DC- als auch mit AC-Versorgungsspannung und -Eingängen betrieben werden können, haben zusätzlich die Anforderung, dass für den DC-Betrieb die Eingänge in der Regel schnell sein sollten, was dann auch für den AC-Betrieb gilt (gleiche Schaltung), so dass eine ausreichende Hardware-Filterung nicht möglich ist. In diesem Fall wäre ein doppeltes Lesen im Abstand von 1 ms (wie im DC-Betrieb) keine optimale Lösung, weil in dieser Zeit die Spannung einen anderen Pegel erreicht und man dadurch Schwierigkeiten beim Einhalten des Umschaltpegels insbesondere für kombinierte AC/DC-Geräte, in denen der Pegel relativ genau einzuhalten ist, bekommen würde.

In einer Ausführungsform erlaubt die hier offenbarte Schaltungsanordnung und das Verfahren das Lesen der AC-Eingänge unter strikter Einhaltung des Umschaltpegels und ermöglicht gleichzeitig die Filterung von Stoßspannungsimpulsen und zwar sowohl für die "einphasige" Erfassung - bei der die Eingänge mit der gleichen Phase wie die Versorgungsspannung beschaltet sind - als auch für die "dreiphasige" Erfassung - bei der die Eingänge mit einer beliebigen Phase beschaltet werden können.

Die Erfindung wird im Folgenden an mehreren Ausführungsbeispielen anhand der Figuren näher erläutert. Funktions- beziehungsweise wirkungsgleiche Komponenten oder Funktionseinheiten tragen gleiche Bezugszeichen.

Insoweit sich Komponenten oder Funktionseinheiten in ihrer Funktion entsprechen, wird deren Beschreibung nicht in jeder der folgenden Figuren wiederholt. Es zeigen:

Figuren 1A und 1B sowie 2 bis 4 Beispiele einer Schaltungsanordnung und von Signalen der Schaltungsanordnung,

Figuren 5 und 6 ein weiteres Beispiel einer Schaltungsanordnung und von Signalen der Schaltungsanordnung,

Figuren 7 bis 11 ein zusätzliches Beispiel einer Schaltungsanordnung und von Signalen der Schaltungsanordnung,

Figuren 12 bis 14 Beispiele für Verfahren der Schaltungsanordnung, und

Figuren 15A bis 15C ein Beispiel eines Details der Schaltungsanordnung und von Signalen der Schaltungsanordnung.

Einphasiges Verfahren:

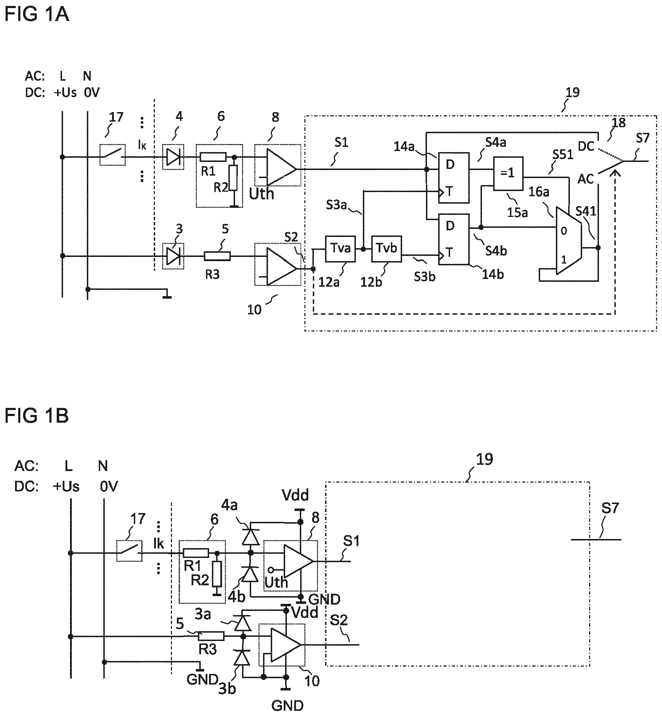

Fig. 1A zeigt ein Beispiel der Schaltungsanordnung zur Erfassung und Entstörung einphasiger AC-Eingänge. Die eingangsseitige Schaltung umfasst einen Nulldurchgangsdetektor 10 mit einem Komparator, einen Gleichrichter 3 und einen Strombegrenzungswiderstand 5 sowie Schaltungen für die Eingänge, hier beispielhaft für ein wechselspannungsförmiges Signal Ik (auch Eingang, Eingangssignal, Wechselspannungssignal oder AC-Eingangssignal genannt) mit einem Gleichrichter 4, einem Spannungsteiler 6 und einem Komparator 8. Die Ausgangssignale sind jeweils ein Komparatorsignal S1 und ein Detektorsignal S2. Die Logikschaltung 19 (auch Logikblock genannt) umfasst zwei Zeitglieder 12a, 12b mit den Verzögerungszeiten Tva und TVb, zwei Flip-Flops 14a, 14b (z.B. als bistabile Kippstufen realisiert), ein Exklusiv-Oder Gatter 15a (auch XOR-Gatter oder exclusive or bezeichnet), einen Multiplexer 16a sowie einen gesteuerten Umschalter 18 (auch Wahlschalter genannt) zwischen AC- und DC-Betrieb.

Die Schaltungsanordnung ist ausgelegt, ein AC-Eingangssignal (sinusförmiges Wechselspannungssignal) und ein DC-Eingangssignal (Gleichspannungssignal) zu verarbeiten. Das AC-Eingangssignal stammt in diesem Beispiel aus einer Phase L eines Versorgungsnetzes. Das DC-Eingangssignal stammt aus einer DC-Quelle +Us. Mit N bzw. 0V ist der Neutralleiter (für AC) bzw. das Bezugspotential (für DC) bezeichnet. Die Schaltungsanordnung findet z.B. Anwendung in einer speicherprogrammierbaren Steuerung, einem Logikrelais oder ähnlichem. Das Detektorsignal S2, das auch als Nulldurchgangssignal bezeichnet werden kann, wird aus der Phase L des Gerätes durch den Nulldurchgangsdetektor 10 erzeugt. Der Nulldurchgangsdetektor 10 ist in Form eines Komparators aufgebaut, der die Versorgungsspannung mit einem Massepotential GND (Null-Referenz) oder einem annähernden Massepotential vergleicht. Auf diese Weise kann die Art des an der Phase L anliegenden Spannungssignals detektiert werden. Liegt ein AC-Eingangssignal an, detektiert der Nulldurchgangsdetektor 10 Nulldurchgänge und erkennt so das anliegende AC-Eingangssignal. In diesem Fall erzeugt der Nulldurchgangsdetektor 10 das Detektorsignal S2. Das Detektorsignal S2 triggert dann wiederum das Zeitglied 12a, das das Taktsignal S3a erzeugt. Liegt dagegen ein DC-Eingangssignal an, detektiert der Nulldurchgangsdetektor 10 keine Nulldurchgänge. In diesem Fall erzeugt der Nulldurchgangsdetektor 10 das Detektorsignal S2 nicht. Auch das Zeitglied 12a wird in diesem Fall nicht getriggert und erzeugt auch das Taktsignal S3a nicht.

Die Versorgungsspannung (Eingangssignal) an der Phase L wird zunächst gleichgerichtet, bevor sie in den Nulldurchgangsdetektor 10 eingespeist wird. Dies ist in Fig. 1A schematisiert in Form der Diode 3 veranschaulicht. Zwischen der Diode 3 und dem Nulldurchgangsdetektor 10 kann ein Widerstand 5 mit dem Wert R3 angeordnet sein. Die Diode 3 führt beispielsweise eine Halbwellengleichrichtung durch, sodass aus dem daraus gewonnenen Signal durch den Nulldurchgangsdetektor 10 das Detektorsignal S2 erzeugt werden kann. Der Nulldurchgangsdetektor 10 ist als Komparator implementiert.

In Fig. 1A wird das Eingangssignal Ik durch den Gleichrichter 4 gleichgerichtet, durch den Spannungsteiler 6 (auch Tiefsetzer genannt, hier in Form eines einfachen Spannungsteilers mit zwei Widerständen R1, R2) heruntergeteilt und durch den Komparator 8 mit einem vordefinierten Schwellenwert Uth verglichen und somit als Komparatorsignal S1 "digitalisiert". Das Eingangssignal Ik ist ein Spannungssignal. Der Gleichrichter weist eine Diode 4 auf, die diskret realisiert sein kann. Eine in Fig. 1A nicht gezeigte Referenzspannungsquelle gibt den Schwellenwert Uth vor. Der Schwellenwert Uth kann z.B. konstant sein.

Im Fall, dass vom Nulldurchgangsdetektor 10 keine Nulldurchgänge des Eingangssignals Ik detektiert werden, wird auch das Detektorsignal S2 und somit das Taktsignal S3a nicht erzeugt. In diesem Fall bleibt der Umschalter 18 in einer oberen Position (DC-Betrieb). In dieser Stellung des Umschalters 18 wird der Ausgang des Komparators 8 (an dem das Komparatorsignal S1 erzeugt wird) unmittelbar auf den Ausgang S7 der Schaltungsanordnung gelegt. Somit liegt das Komparatorsignal S1 am Ausgang S7 an. So kann bei Vorliegen eines DC-Eingangssignals dieses vom Komparator 8 überwacht werden. Überschreitet das DC-Eingangssignal den vorgegebenen Schwellenwert Uth, so erzeugt der Komparator 8 das Komparatorsignal S1 und gibt dieses über den Umschalter 18 unmittelbar am Ausgang S7 aus.

Im alternativen Fall, dass vom Nulldurchgangsdetektor 10 Nulldurchgänge des Eingangssignals Ik detektiert werden, wird auch das Detektorsignal S2 und somit das Taktsignal S3a erzeugt (siehe obige Erläuterungen). In diesem Fall schaltet der Umschalter 18 - getriggert durch den Nulldurchgangsdetektor 10 oder das Zeitglied 12a (z.B. über das Detektorsignal S2, das Taktsignal S3 oder ein anderes Steuersignal, siehe gestrichelte Linie in Fig. 1A) - auf die in Fig. 1A dargestellte untere Position (AC-Betrieb) um. In dieser Stellung des Umschalters 18 wird der Ausgang des Komparators 8, d.h. das Komparatorsignal S1 an den Dateneingang D des Flip-Flops 14a eingespeist. Der Takteingang Clk wird von dem erzeugten Taktsignal S3a gesteuert. Die Komponenten 12a, 12b, 14a, 14b, 15a, 16a und 18 sind im Ausführungsbeispiel gemäß Fig. 1A in einem Mikrocontroller, der die Logikschaltung 19 realisiert, implementiert. Das erste Komparatorsignal S1 wird einem Eingang des Mikrocontrollers zugeführt. Das Detektorsignal S2 wird einem Interrupt-Eingang des Mikrocontrollers zugeführt.

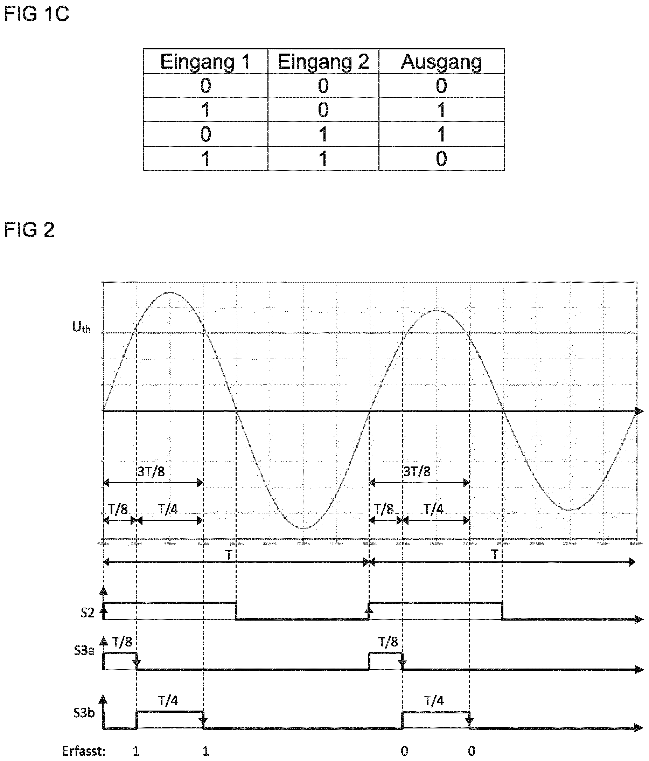

Die Generierung und Funktion des Taktsignal S3a, S3b wird nachfolgend im Detail erläutert (vergleiche Fig. 2 bis 4). Hierbei wird davon ausgegangen, dass ein AC-Eingangssignal Ik anliegt und der Umschalter 18 im AC-Betrieb gestellt ist.

Ausgehend vom Detektorsignal S2 erzeugt das Zeitglied 12a das Taktsignal S3a als Takt für das Flip-Flop 14a. Das Taktsignal S3a weist einen definierten Zustandswechsel (fallende Taktflanke, siehe Fig. 2) auf, der nach einer Verzögerung von T/8 einer Periodendauer T nach einem Nulldurchgang des AC-Eingangssignals Ik (detektiert durch das Detektorsignal S2) auftritt. Das Zeitglied 12b erzeugt das Taktsignal S3b als Takt für das Flip-Flop 14b. Das Taktsignal S3b weist einen Zustandswechsel (fallende Taktflanke, siehe Fig. 2) auf, der nach einer Verzögerung von 3T/8 einer Periodendauer T nach einem Nulldurchgang des AC-Eingangssignals Ik auftritt. An diesen Zeitpunkten liegt der Effektivwert des sinusförmigen AC-Eingangssignals Ik vor. Dies kann mathematisch durch folgende Berechnung gezeigt werden. Das sinusförmige AC-Eingangssignals Ik entspricht.

$$u(t) = U_{peak} \sin(\omega t)$$

mit dem Spitzen-(Peak-)wert Upeak. Löst man diese mathematische Signalbeschreibung folgendermaßen auf:

$$\omega t = \arcsin\left(\frac{u(t)}{\sqrt{2}U_{rms}}\right)$$

wobei Upeak=√2 Urms und Urms dem Effektivwert entspricht, so erhält man für den gewünschten Zeitpunkt tx, an dem der Effektivwert Urms vorliegt, folgende Beziehung:

$$\omega t_X = \arcsin\left(\frac{u(t_X)}{\sqrt{2}U_{rms}}\right) = \arcsin\left(\frac{U_{rms}}{\sqrt{2}U_{rms}}\right) = \arcsin\left(\frac{1}{\sqrt{2}}\right) = \frac{\pi}{4} \quad \text{bzw.}$$

$$t_X = \frac{1}{\omega}\frac{\pi}{4} = \frac{T}{2\pi}\frac{\pi}{4} = \frac{T}{8}.$$

Nachdem gilt: $\sin(\omega t) = \sin\left(\omega t + \frac{\pi}{2}\right)$ erhält man für den zweiten möglichen Zeitpunkt tx:

$$\omega t_X = \frac{\pi}{4} + \frac{\pi}{2} = \frac{3\pi}{4} \quad \text{bzw.} \quad t_X = \frac{1}{\omega}\frac{3\pi}{4} = \frac{T}{2\pi}\frac{3\pi}{4} = \frac{3T}{8}.$$

Somit liegt zu den Zeitpunkten T/8 bzw. 3T/8 einer Periodendauer T nach einem Nulldurchgang des AC-Eingangssignals Ik jeweils der Effektivwert des AC-Eingangssignals Ik vor.

Das Taktsignal S3a triggert das Flip-Flop 14a an dessen flankengesteuertem Eingang Clk, wobei zum jeweiligen Zeitpunkt eines entsprechenden Zustandswechsels (fallende Taktflanke) des Taktsignals S3a (bei T/8) der Wert des Komparatorsignals S1 am Dateneingang D des Flip-Flops 14a übernommen wird und somit ein erstes Zustandssignal S4a am Ausgang des Flip-Flops 14a erzeugt wird. Alternativ kann bei geeigneter Auslegung des Taktsignals S3a und des Flip-Flops 14a anstelle einer fallenden Taktflanke auch eine steigende Taktflanke verwendet werden.

Entsprechend triggert das Taktsignal S3b das Flip-Flop 14b an dessen flankengesteuertem Eingang Clk, wobei zum jeweiligen Zeitpunkt eines entsprechenden Zustandswechsels (fallende Taktflanke) des Taktsignals S3a (bei 3T/8) der Wert des Komparatorsignals S1 am Dateneingang D des Flip-Flops 14b übernommen wird und somit ein zweites Zustandssignal S4b am Ausgang des Flip-Flops 14b erzeugt wird.

Schließlich wird ein Wechselspannungszustandssignal am Ausgang S7 bereitgestellt und kann weiter verarbeitet werden, z.B. durch eine Logikschaltung des elektronischen Gerätes (nicht dargestellt), in dem die Schaltungsanordnung Anwendung findet.

Ist das Eingangssignal Ik gleich Null (Schalter 17 geöffnet), so ist das Komparatorsignal S1 des Komparators 8 immer "0" und in den Flip-Flops 14a, 14b wird zu jedem Zeitpunkt der Wert "0" gespeichert. Liegt ein gültiges Eingangssignal Ik an, das die Vergleichsschwelle (Schwellenwert Uth) des Komparators 8 überschreitet, so weist das Komparatorsignal S1 ein Impuls auf. Im Falle eines sinusförmigen AC-Eingangssignals Ik ist der Impuls des Komparatorsignal S1 um den Scheitelpunkt des Eingangssignals Ik zentriert, wobei dessen Breite von der tatsächlichen Amplitude des AC-Eingangssignals Ik abhängt, d.h. je höher die Amplitude, desto breiter ist der Impuls des Komparatorsignals S1. Durch Auswerten des Komparatorsignals S1 in den Flip-Flops 14a, 14b zu den Zeitpunkten T/8 und 3T/8, getriggert durch die Taktsignale S3a, S3b der Zeitglieder 12a, 12b kann somit das AC-Eingangssignal Ik hinsichtlich seines Effektivwertes ausgewertet werden.

Fig. 1B zeigt ein alternatives Beispiel der Schaltungsanordnung, die eine Weiterbildung des in Fig. 1A gezeigten Beispiels ist. Im Unterschied zu Fig. 1A wird in Fig. 1B ein anliegendes Eingangssignal Ik zuerst dem Tiefsetzer 6 zugeführt. Das Ausgangssignal des Tiefsetzers 6 wird durch eine erste und eine zweite Diode 4a, 4b gleichgerichtet. Die erste Diode 4a verbindet den Eingang des Komparators 8 mit einem Versorgungsspannungsanschluss. Am Versorgungsspannungsanschluss liegt eine Versorgungsspannung Vdd an. Die erste Diode 4a ist derart gepolt, dass eine Spannung am Eingang des Komparators 8 kleiner als die Versorgungsspannung Vdd (ggf. zuzüglich einer Schwellenspannung der ersten Diode 4a) ist. Die zweite Diode 4b verbindet den Eingang des Komparators 8 mit einem Massepotentialanschluss, an dem das Massepotential GND anliegt. Die zweite Diode 4b ist derart gepolt, dass die Spannung am Eingang des Komparators 8 größer als das Massepotential GND (ggf. abzüglich einer Schwellenspannung der zweiten Diode 4b) ist.

Der Komparator 8 kann als bipolarer Komparator realisiert sein. Der Komparator 8 erzeugt das Komparatorsignal S1 in Abhängigkeit von einem Vergleich der Spannung am Eingang des Komparators 8 und des Schwellenwerts Uth. Das Komparatorsignal S1 ist impulsförmig. Der Impuls des Komparatorsignals S1 wird vom der Logikschaltung 19 zeitlich erfasst, so wie in Fig. 1a angegeben.

Alternativ kann der Komparator 8 als Inverter implementiert werden. Die Dioden 4a, 4b können z.B. im Inverter integriert sein. Die Dioden 4a, 4b können als Schutzdioden realisiert sein. Der Inverter weist einen "eingebauten" Schwellenwert Uth auf. Die erste und die zweite Diode 4a, 4b können optional zusammen mit dem Inverter auf einem Halbleiterkörper integriert sein (z.B. ein CMOS-Inverter vom Typ HC04).

Zur Erzeugung des Detektorsignals S2 durch den Nulldurchgangsdetektor 10 wird im Beispiel gemäß Fig. 1B ein anliegendes Eingangssignal Ik zuerst dem Widerstand 5 mit dem Wert R3 zugeführt und dann durch eine erste und eine zweite Diode 3a, 3b gleichgerichtet. Die erste Diode 3a verbindet den Eingang des Nulldurchgangsdetektors 10 mit dem Versorgungsspannungsanschluss. Die erste Diode 3a ist derart gepolt, dass eine Spannung am Eingang des Nulldurchgangsdetektors 10 kleiner als die Versorgungsspannung Vdd (ggf. zuzüglich einer Schwellenspannung der ersten Diode 3a) ist. Die zweite Diode 3b verbindet den Eingang des Nulldurchgangsdetektors 10 mit dem Massepotentialanschluss. Die zweite Diode 3b ist derart gepolt, dass die Spannung am Eingang des Nulldurchgangsdetektors 10 größer als das Massepotential GND (ggf. abzüglich einer Schwellenspannung der zweiten Diode 3b) ist. Das Detektorsignal S2 ist impulsförmig.

Der Nulldurchgangsdetektors 10 kann als bipolarer Komparator realisiert sein.

Alternativ kann der Nulldurchgangsdetektors 10 als Inverter implementiert sein. Die Dioden 3a, 3b können z.B. im Inverter integriert sein. Die Dioden 3a, 3b können als Schutzdioden realisiert sein. Der Nulldurchgangsdetektor 10 weist einen "eingebauten" Schwellenwert auf. Da die dem Nulldurchgangsdetektor 10 zugeführte Spannung nicht heruntergeteilt ist, ist der Spannungsanstieg schnell. So ist der zeitliche Versatz zwischen dem Nulldurchgang der zugeführten Spannung und dem Schalten des Nulldurchgangsdetektors 10 sehr gering und kann vernachlässigt werden.

Der Schwellenwert des Nulldurchgangsdetektors 10 kann 0 V (also das Massepotential, wie in Fig. 1B) oder eine von 0 V verschiedene Spannung sein, z.B. eine kleine positive Spannung (z.B. 2 V).

In alternativen, nicht gezeigten Ausführungsformen, kann der Komparator 8 und/oder der Nulldurchgangsdetektor 10 als ein CMOS-Gatter, z.B. ein CMOS-Gatter vom Typ HC, oder als ein Transistor realisiert werden. Beim Transistor kann der Schwellenwert Uth z.B. diejenige Basis-Emitter Spannung sein, ab der ein Strom durch den Transistor fließt (z.B. Ube = ca. 0,65 V). Die Widerstandwerte der Widerstände R1, R2 des Tiefsetzers 6 sind dann entsprechend dimensioniert. Es können dann ausschließlich die zweiten Dioden 4b bzw. 3b vorgesehen sein. Die ersten Dioden 4a bzw. 3a können weggelassen werden.

Der Komparator 8 kann als ein Baustein, dem die Dioden 4a, 4b als Schutzdioden extern vorgeschaltet sind, oder als ein Baustein mit integrierten Dioden 4a, 4b (wie z.B. ein CMOS-Inverter mit Schutzdioden etwa HC04) hergestellt sein.

Der Nulldurchgangsdetektor 10 kann als ein Baustein, dem die Dioden 3a, 3b als Schutzdioden extern vorgeschaltet sind, oder als ein Baustein mit integrierten Dioden 3a, 3b (wie z.B. ein CMOS-Inverter mit Schutzdioden etwa HC04) hergestellt sein. Die Schutzdioden können Schutzdioden gegen elektrostatische Aufladung, abgekürzt ESD-Schutzdioden, sein.

Die Vorverarbeitung (Gleichrichten, Tiefsetzen) ist in Figuren 1A und 1B ausschließlich beispielhaft dargestellt und kann auch mit alternativen Schaltungen realisiert sein. Das Gleichrichten kann gegebenenfalls entfallen. Die Vorverarbeitung ist ausgelegt, den Komparator 8 und/oder den Nulldurchgangsdetektor 10 gegen Über- und Unterspannungen zu schützen. Diese Funktion kann optional auch eine Gleichrichterdiode 3b, 4b für negative Unterspannungen übernehmen. Ggf. kann ein zusätzlicher Schutz gegen Überspannung vorgesehen sein.

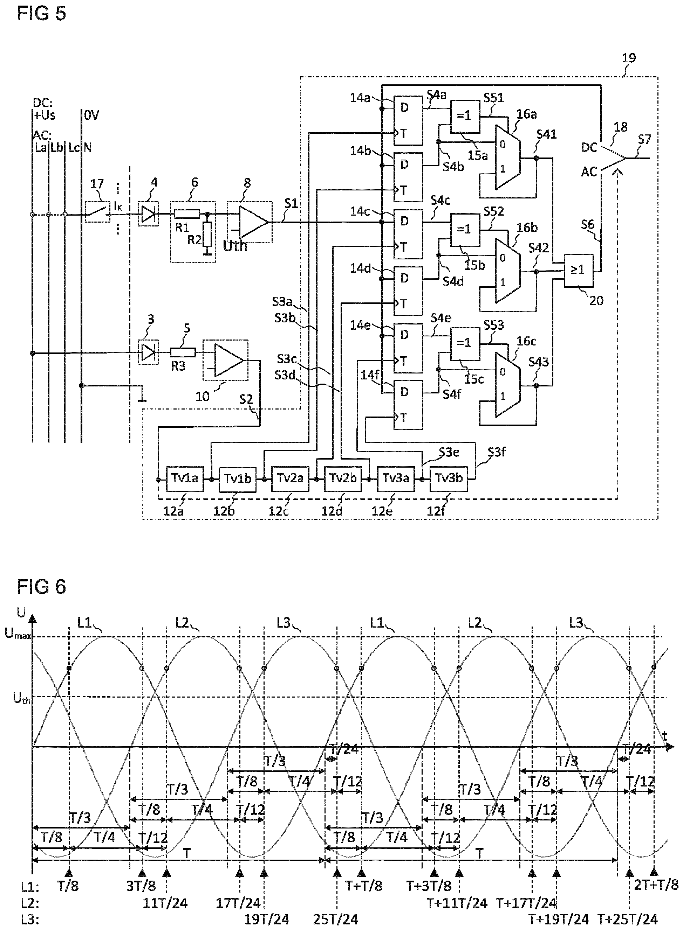

Die in Figur 1B gezeigte Schaltung kann auch mit den in Figuren 5, 7 und 15A gezeigten Logikschaltungen 19 kombiniert werden.

In Figur 1C ist die Wahrheitstabelle der Exklusiv-Oder - Gatters 15a, d.h. die Funktion XOR gezeigt. Sind beide Eingangssignale identisch, 00 oder 11, so ist das Ausgangssignal 0; sind die Eingangssignale unterschiedlich, 01 oder 10, so ist das Ausgangssignal 1.

Fig. 2 zeigt das sinusförmige Eingangssignal. Die zwei Erfassungszeitpunkte während der positiven Halbwelle, an denen das Signal die gleiche Amplitude hat, sind $T/8$ (bzw. 45°, bzw. $n/4$) und $3T/8$ (bzw. 135°, bzw. $3n/4$). Das Signal wird in beiden Zeitpunkten erfasst. Im Normalfall liegen die Werte entweder beide auf 1 oder beide auf 0, je nach Amplitude des Eingangssignals Ik, wie in der ersten bzw. zweiten Periode T in Fig. 2.

Das Detektorsignal S2, auch Nulldurchgangssignal genannt, triggert mit der ersten Flanke (z.B. die positive in Fig. 2) das erste Zeitglied 12a, das einen Impuls S3a mit der Dauer $T/8$ erzeugt. Dieser speichert mit der zweiten Flanke (z.B. die negative Flanke in Fig. 2) das Komparatorsignal S1, das das digitalisierte Eingangssignal darstellt, in das Flip-Flop 14a und triggert gleichzeitig das zweite Zeitglied 12b. Dieser erzeugt einen weiteren Impuls S3b mit der Dauer $T/4$, der dann mit der zweiten Flanke das Komparatorsignal S1 in das Flip-Flop 14b speichert und zwar zum Zeitpunkt $T/8 + T/4 = 3T/8$. Die gespeicherten Zustandssignale S4a, S4b der Flip-Flops 14a, 14b werden durch das XOR-Gatter 15a miteinander verglichen.

Im Normalfall sind beide Zustandssignale S4a, S4b gleich, entweder [0,0] oder [1,1] und ist somit ein erstes Verarbeitungssignal S51 = 0 (auch XOR-Ausgang genannt). Das erste Verarbeitungssignal S51 steuert den Multiplexer 16a an und für den Wert 0 wird der Eingang "0" zum erste Ausgangssignal S41 zugeschaltet, also das erste Zustandssignal S4b. Sollte nun das erste Zustandssignal S4a den anderen Wert annehmen, so wird im Zeitpunkt $T/8$ erst das erste Verarbeitungssignal S51 = 1. Dadurch schaltet der Multiplexer 16a um und leitet an seinem Ausgang erstmal den Eingang "1", was das vorherige erste Ausgangssignal S41 ist, also der Wert wird beibehalten. Folgt zum Zeitpunkt $3T/8$ auch S4b mit dem neuen Wert von S4a, wie im Falle eines Eingangssignals-Wertwechsel, so wird S51 = 0, der Multiplexer 16a schaltet wieder zum Eingang "0" und der neue Eingangswert wird als erstes Ausgangssignal S41 weitergegeben. Bleibt jedoch S4b beim alten Wert (ungleich S4a), dann handelt es sich um eine Störung, der Multiplexer 16a bleibt auf Eingang "1" und der alte Wert wird somit beibehalten, bis beide Zustandssignale S4a, S4b wieder den gleichen Wert annehmen.

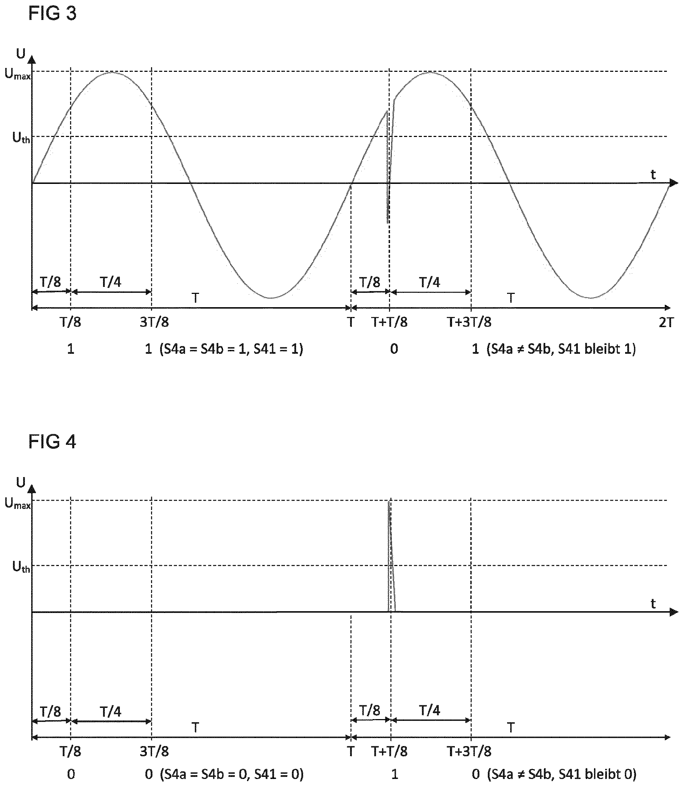

Fig. 3 zeigt beispielsweise den Fall mit aktivem Eingangssignal Ik = 1 oder "high" bzw. $uin(t) = Umax \sin(\omega t)$, das in der zweiten Periode durch einen negativen Störimpuls verfälscht wird und zwar zum Zeitpunkt der ersten Erfassung in $T/8$. In der ersten Periode sind beide erfassten Werte 1, S4a = S4b = 1, S51 = 0, der Multiplexer 16a auf Eingang "0" und das erste Ausgangssignal S41 = S4b = 1. In der zweiten Periode sind die Werte ungleich, S4a = 0, S4b = 1, somit das erste Verarbeitungssignal S51 = 1, der Multiplexer 16a auf Eingang "1" und das erste Ausgangssignal S41 bleibt beim vorherigen Wert 1. Dadurch wird der Störimpuls unterdrückt. Hätte man eine einzige Erfassung in $T/8$ implementiert, so wäre das erste Ausgangssignal S41 und das Ausgangssignal am Ausgang S7 verfälscht. In gleicher Weise funktioniert die Entstörung, wenn die zweite Erfassung in $3T/8$ gestört wird.

Fig. 4 zeigt beispielsweise den Fall mit inaktivem Eingangssignal Ik = 0 oder "low" bzw. $uin(t) = 0$, das in der zweiten Periode durch einen positiven Störimpuls verfälscht wird und zwar zum Zeitpunkt der ersten Erfassung in $T/8$. In der ersten Periode sind beide erfassten Werte 0, S4a = S4b = 0, S51 = 0, der Multiplexer 16a auf Eingang "0" und das erste Ausgangssignal S41 = S4b = 0. In der zweiten Periode sind die Werte ungleich, S4a = 1, S4b = 0, somit S51 = 1, der Multiplexer 16a auf Eingang "1" und das erste Ausgangssignal S41 bleibt beim vorherigen Wert 0. Dadurch wird der Störimpuls unterdrückt. In gleicher Weise funktioniert die Entstörung, wenn die zweite Erfassung in $3T/8$ verfälscht wird.

Die Offenbarung betrifft vor allem den AC-Betrieb. Für universelle Geräte, die sowohl AC- als auch DC-versorgt werden können, mit dann entsprechenden AC- oder DC-Eingängen, kann optional am Ausgang der Logikschaltung 19 noch ein steuerbarer Umschalter 18 zwischen dem AC- und dem DC-Betrieb vorgesehen sein. Dadurch wird am Ausgang S7 entweder direkt das Komparatorsignal S1 für den DC-Betrieb oder das erste Ausgangssignal S41 für den AC-Betrieb zugeschaltet. Die Ansteuerung erfolgt durch eine in Fig. 1 nicht näher gezeigte Schaltung vom Detektorsignal S2 (oder einem der Talksignale S3a, S3b). Im Falle der AC-Versorgung sind diese Signale impulsförmig, bei DC-Versorgung statisch. Die Impulse könnten z.B. ein retriggerbares Monoflop (monostabile Kippstufe) ansteuern und so zwischen AC (Ausgang aktiv) und DC (Ausgang inaktiv) unterscheiden.

Die Logikschaltung (auch Logikblock genannt) kann z.B. in der Firmware eines Mikrocontrollers implementiert werden.

Dreiphasiges Verfahren:

Fig. 5 zeigt ein Beispiel der Schaltungsanordnung zur Erfassung und Entstörung dreiphasiger AC-Eingänge. Die eingangsseitige Schaltung umfasst den Nulldurchgangsdetektor mit beispielsweise dem Gleichrichter 3, den Strombegrenzungswiderstand 5 und den Komparator 10, sowie Schaltungen für die Eingänge, hier beispielhaft für ein Eingangssignal Ik mit dem Gleichrichter 4, dem Spannungsteiler 6 und dem Komparator 8 dargestellt. Die Ausgangssignale sind jeweils das Komparatorsignal S1 und das Detektorsignal S2. Der Logikblock 19 umfasst sechs Zeitglieder "Tv1a" 12a, "TV1b" 12b, "Tv2a" 12c, "TV2b" 12d, "Tv3a" 12e, "TV3b" 12f, sechs Flip-Flops (bistabile Kippstufen) 14a, 14b, 14c, 14d, 14e, 14f, drei XOR-Gatter (exclusive or) 15a, 15b, 15c, drei Multiplexer 16a, 16b, 16c, einen ODER-Gatter 20 mit drei Eingängen sowie den gesteuerten Umschalter 18 zwischen AC- und DC-Betrieb.

Um den gemischten AC/DC-Betrieb zu unterstützen, wird das Eingangssignal Ik nicht im Scheitelpunkt (T/4) erfasst, sondern in T/8 und für die Entstörung auch in 3T/8 der jeweiligen Phase.

Fig. 6 zeigt die sechs Erfassungspunkte, zwei pro Phase. Bezogen auf die Versorgungsphase z.B. L1 sind diese:

- T/8 und 3T/8 für die Versorgungsphase, z.B. L1
- 11T/24 und 17T/24 für die nachfolgende Phase z.B. L2 (T/3 + T/8 und T/3 + 3T/8)
- 19T/24 und 25T/24 für die dritte Phase z.B. L3 (2T/3 + T/8 und 2T/3 + 3T/8)

Im Falle der verketteten Zeitglieder, so wie in Fig. 5 dargestellt, sind dann die Zeiten:

- Tv1a = T/8 (Gesamtzeit T/8, erster Erfassungspunkt Phase 1)
- Tv1b = T/4 (Gesamtzeit T/8 + T/4 = 3T/8, zweier Erfassungspunkt Phase 1)
- Tv2a = T/12 (Gesamtzeit 3T/8 + T/12 = 11T/24, erster Erfassungspunkt Phase 2)
- Tv2b = T/4 (Gesamtzeit 11T/24 + T/4 = 17T/24, zweiter Erfassungspunkt Phase 2)
- Tv3a = T/12 (Gesamtzeit 17T/24 + T/12 = 19T/24, erster Erfassungspunkt Phase 3)
- Tv3b = T/4 (Gesamtzeit 19T/24 + T/4 = 25T/24, zweiter Erfassungspunkt Phase 3)

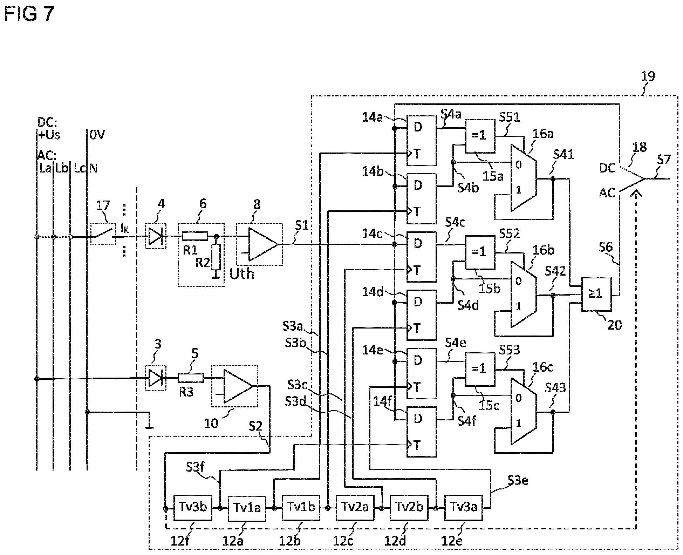

Man kann erkennen, dass die Auswertung der dritten Phase über die Periode hinausgeht, 25T/24 = T + T/24, so dass praktisch der erste Erfassungspunkt am Anfang einer Periode (also T/24 nach Nulldurchgang) der zweite Erfassungspunkt der dritten Phase ist. In der dargestellten Anordnung bedeutet das, dass das letzte Zeitglied für T/24 parallel zum ersten Zeitglied läuft. Für eine Implementierung in der Firmware eines Mikrocontrollers wären dafür mindestens zwei separate Zeitgeber, englisch Timer vorzusehen. Steht nur einer zur Verfügung, weil z. B. die anderen für andere Aufgaben verwendet werden, so kann man die verketteten Zeitglieder auch anders anordnen und zwar wie in Fig. 7 dargestellt.

Fig. 7 zeigt ein alternatives Beispiel der Schaltungsanordnung zur Erfassung und Entstörung dreiphasiger AC-Eingänge, die eine Weiterbildung der in Fig. 1A, 1B und 5 gezeigten Beispiele ist. Am Anfang der Kette ist Tv3b angeordnet, gefolgt von Tvla, Tvlb, Tv2a, Tv2b und Tv3a. Die entsprechenden Zeiten sind dann:

- Tv3b = T/24 (Gesamtzeit T/24, zweiter Erfassungspunkt Phase 3)
- Tv1a = T/12 (Gesamtzeit T/24 + T/12 = 3T/24 = T/8, erster Erfassungspunkt Phase 1)
- Tv1b = T/4 (Gesamtzeit T/8 + T/4 = 3T/8, zweiter Erfassungspunkt Phase 1)
- Tv2a = T/12 (Gesamtzeit 3T/8 + T/12 = 11T/24, erster Erfassungspunkt Phase 2)
- Tv2b = T/4 (Gesamtzeit 11T/24 + T/4 = 17T/24, zweiter Erfassungspunkt Phase 2)
- Tv3a = T/12 (Gesamtzeit 17T/24 + T/12 = 19T/24, erster Erfassungspunkt Phase 3)

In diesem Fall kann ein einziger Timer für die Firmware-Implementierung verwendet werden, da ausgehend vom Nulldurchgang der Versorgungsphase (Detektorsignal S2) keine der Zeitglieder gleichzeitig laufen.

Alternativ kann man die Zeitglieder auch parallel anordnen mit entsprechend berechneten Zeiten. Das wäre für eine Hardware-Implementierung kein Problem, jedoch für eine Implementierung in der Firmware eines Mikrocontrollers ungünstig, denn man benötigte sechs separate Timer.

Ausgehend vom Nulldurchgang der Versorgungsphase "La" in Fig. 5 (z.B. L1), werden die Zeitglieder Tvla, Tvlb, TV2a, Tv2b, Tv3a, Tv3b derart getriggert, dass die Taktsignale S3a bis S3f genau zu den vorher beschriebenen Erfassungs-Zeitpunkten schalten. Diese werden jeweils einem Flip-Flop 14a bis 14f zum Takteingang zugeführt. Auf dem Dateneingang D liegt jeweils das Komparatorsignal S1 an. In dieser Weise wird in den Flip-Flops 14a bis 14f der Zustand des Komparatorsignals S1 zum jeweiligen Zeitpunkt gespeichert. Pro Phase entspricht das den Werten zu den Zeitpunkten T/8 und 3T/8 ausgehend vom Nulldurchgang der jeweiligen Phase, wobei an den Zeitpunkten T/8 und 3T/8 das sinusförmige Signal den gleichen Wert aufweist. Die Taktsignale S3a bis S3f unterscheiden sich. Die Flip-Flops 14a bis 14f können flankengesteuert sein.

Das sind das erste und das zweite Zustandssignal S4a, S4b für die erste Phase "La" (Versorgungsphase, z.B. L1), das dritte und das vierte Zustandssignal S4c, S4d für die zweite Phase "Lb" (z.B. L2), bzw. das fünfte und das sechste Zustandssignal S4e, S4f für die dritte Phase "Lc" (z.B. L3). Die jeweils zwei Signale für jede Phase werden von den XOR-Gattern 15a, 15b, 15c miteinander verglichen und durch deren Ausgangsignale, nämlich dem ersten, zweiten und dritten Verarbeitungssignal S51, S52, S53 werden die Multiplexer 16a, 16b, 16c entsprechend angesteuert. Wenn jeweils die zwei Zustandssignale gleich sind, wird der Wert als das erste, zweite und dritte Ausgangssignal S41, S42, S43 übernommen, wenn nicht wird der vorherige Wert des Ausgangsignals S41, S42, S43 beibehalten. Schließlich werden die Ausgangsignale S41, S42, S43 durch das ODER-Gatter 20 verarbeitet und ein Wechselspannungszustandssignal S6 am Ausgang des ODER-Gatters 20 und daraus das Ausgangsignal am Ausgang S7 erzeugt.

In der in Fig. 7 gezeigten Logikschaltung 19 sind die Ausgänge des ersten und des letzten Zeitglieds 12f, 12e mit den Flip-Flops 14e, 14f verbunden. Die Ausgänge des zweiten und dritten Zeitglieds 12a, 12b sind mit den Flip-Flops 14a, 14b sowie die Ausgänge des vierten und des fünften Zeitglieds 12c, 12d mit den Flip-Flops 14c, 14d verbunden. Mit Vorteil ist ein Timer im Mikrocontroller, der die Logikschaltung 19 realisiert, ausreichend.

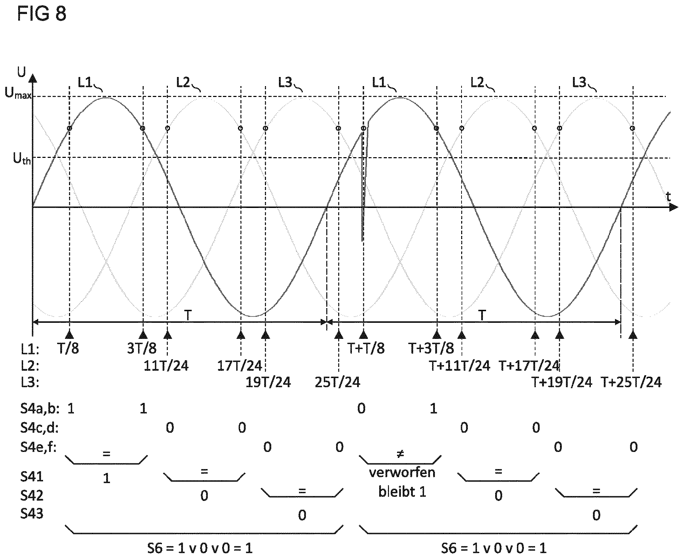

Fig. 8 zeigt beispielsweise den Fall mit aktivem Eingangssignal Ik = 1 oder "high" bzw. uin(t) = Umax sin($\omega$t) aus der Versorgungsphase (hier L1) gespeist, das in der zweiten Periode durch einen negativen Störimpuls verfälscht wird und zwar zum Zeitpunkt der ersten Erfassung in T/8. In der ersten Periode sind S4a = S4b = 1, S4c = S4d = 0, S4e = S4f = 0. Da jeweils die zwei Werte pro Phase gleich sind, werden alle an den Ausgängen der Multiplexer 16a - 16c weitergeleitet, also S41 = 1, S42 = 0, S43 = 0 und am Ausgang des ODER-Gatters 20 ist das Wechselspannungszustandssignal S6 = 1. In der zweiten Periode verfälscht die Störung die erste Erfassung in T/8, wodurch S4a = 0 und S4b = 1. Da S4a ≠ S4b schaltet der XOR-Gatter 15a durch S51 = 1 den Multiplexer 16a auf Eingang "1" und das erste Ausgangssignal S41 bleibt beibehalten S41 = 1. Die anderen erfassten Werte sind jeweils gleich, S4c = S4d = 0, S4e = S4f = 0 und werden somit weitergeleitet als zweites Ausgangssignal S42 = 0 bzw. drittes Ausgangssignal S43 = 0. Die ODER-Verknüpfung ergibt wieder das Wechselspannungszustandssignal S6 = 1, somit ist die Störung eliminiert.

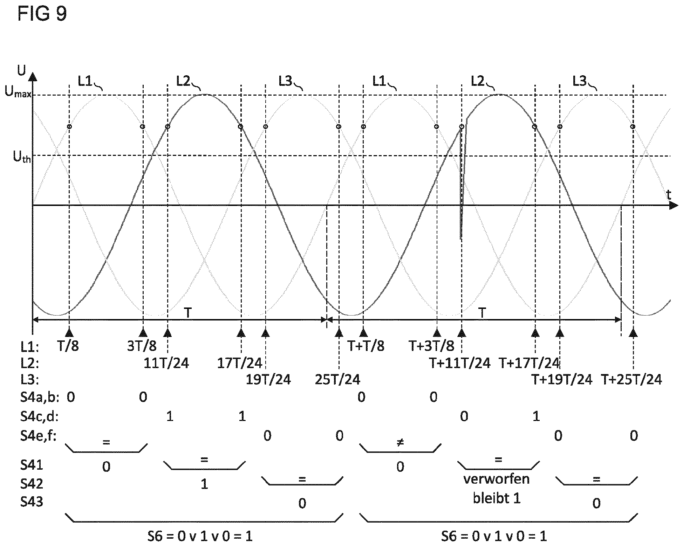

Fig. 9 zeigt beispielsweise den Fall mit aktivem Eingangssignal Ik = 1 oder "high" bzw. uin(t) = Umax sin[$\omega$(t - T/3)] aus der nächsten Phase nach der Versorgungsphase (hier L2) gespeist, das in der zweiten Periode durch einen negativen Störimpuls verfälscht wird und zwar zum Zeitpunkt der ersten Erfassung in 11T/24. In der ersten Periode sind S4a = S4b = 0, S4c = S4d = 1, S4e = S4f = 0. Da jeweils die zwei Werte pro Phase gleich sind, werden alle an die Ausgänge der Multiplexer 16a - 16c weitergeleitet, also S41 = 0, S42 = 1, S43 = 0 und am Ausgang des ODER-Gatters 20 ist S6 = 1. In der zweiten Periode verfälscht die Störung die erste Erfassung in 11T/24, wodurch S4c = 0 und S4d = 1. Da S4c ≠ S4d schaltet das XOR-Gatter 15b durch das zweite Verarbeitungssignal S52 = 1 den Multiplexer 16b auf Eingang "1" und das zweite Ausgangssignal S42 bleibt beibehalten S42 = 1. Die anderen erfassten Werte sind jeweils gleich, S4a = S4b = 0, S4e = S4f = 0 und werden somit weitergeleitet an S41 = 0 bzw. S43 = 0. Die ODER-Verknüpfung ergibt wieder S6 = 1, somit ist die Störung eliminiert.

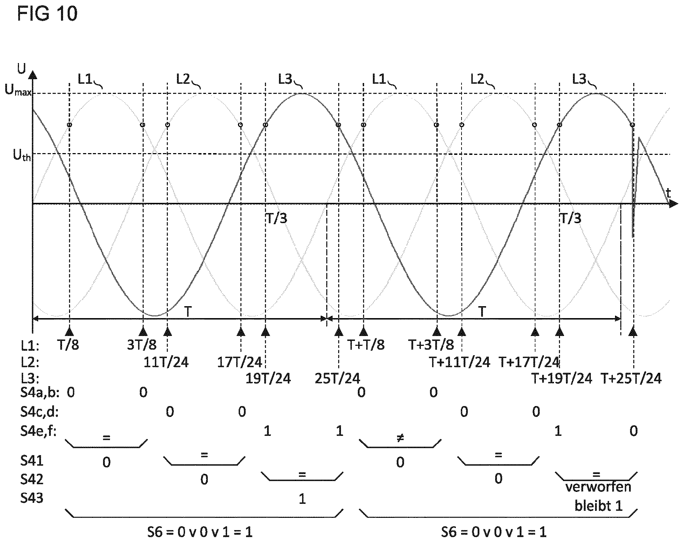

Fig. 10 zeigt beispielsweise den Fall mit aktivem Eingangssignal Ik = 1 oder "high" bzw. uin(t) = Umax sin[$\omega$(t - 2T/3)] aus der dritten Phase nach der Versorgungsphase (hier L3) gespeist, das in der zweiten Periode durch einen negativen Störimpuls verfälscht wird und zwar diesmal zum Zeitpunkt der zweiten Erfassung in 25T/24. In der ersten Periode sind S4a = S4b = 0, S4c = S4d = 0, S4e = S4f = 1. Da jeweils die zwei Werte pro Phase gleich sind, werden alle an die Ausgänge der Multiplexer 16a - 16c weitergeleitet, also S41 = 0, S42 = 0, S43 = 1 und am Ausgang des ODER-Gatters 20 ist S6 = 1. In der zweiten Periode verfälscht die Störung die zweite Erfassung in 25T/24, wodurch S4e = 1 und S4f = 0. Da S4e ≠ S4f schaltet das XOR-Gatter 15c durch das dritte Verarbeitungssignal S53 = 1 den Multiplexer 16c auf Eingang "1" und das dritte Ausgangssignal S43 bleibt beibehalten S43 = 1. Die anderen erfassten Werte sind jeweils gleich, S4a = S4b = 0, S4c = S4d = 0 und werden somit weitergeleitet an S41 = 0 bzw. S42 = 0. Die ODER-Verknüpfung ergibt wieder S6 = 1, somit ist die Störung eliminiert.

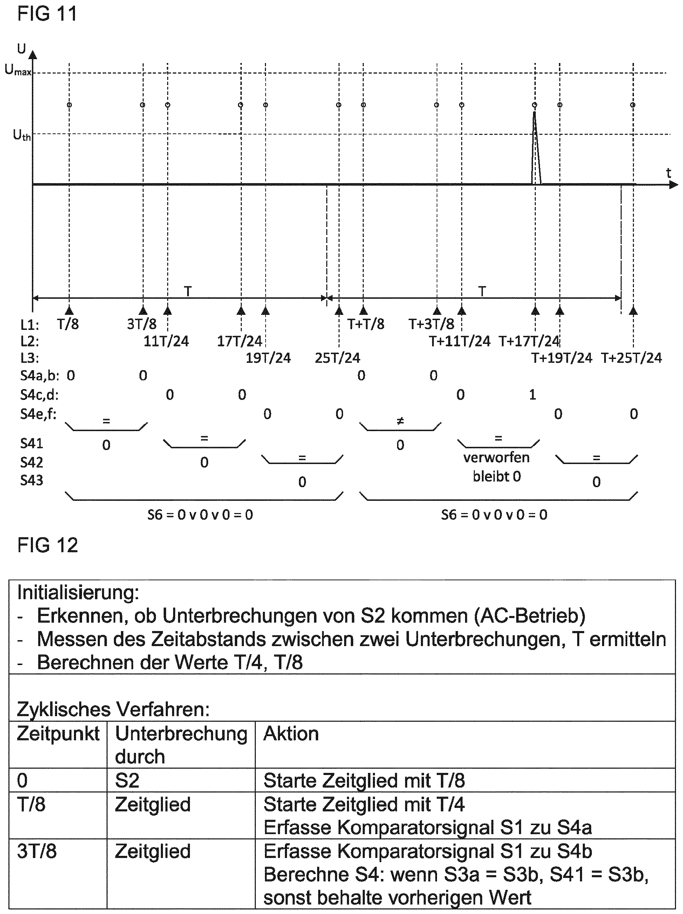

In gleicher Weise funktioniert die Entstörung, wenn das Eingangssignal Ik 0 ist. Egal zu welchem Erfassungszeitpunkt eine positive Störung den Eingangswert von 0 auf 1 verfälscht, wird diese Einzelstörung eliminiert. Beispielhaft wird im Fig. 11 der Fall dargestellt, wenn das inaktive Eingangssignal (Ik = 0 oder "low" bzw. uin(t) = 0) durch einen positiven Störimpuls in der zweiten Periode zum Zeitpunkt 17T/24 - das entspricht dem zweiten Lesepunkt der zweiten Phase, hier der Phase L2, wenn die Versorgungsphase L1 ist - verfälscht wird. In der ersten Periode sind alle erfassten Werte S4a - S4f = 0 und werde an die Multiplexer-Ausgänge mit den Ausgangssignalen S41 - S43 weitergeleitet.

Das ODER-Gatter 20 ergibt dann S6 = 0. In der zweiten Periode verfälscht die Störung das Signal S4d = 1.

EP 3 948 311 B1

Weil S4c = 0 und so S4c ≠ S4d, schaltet das XOR-Gatter 15b durch S52 = 1 den Multiplexer 16b auf Eingang "1" und der Ausgang bleibt beibehalten S42 = 0. Die anderen erfassten Werte sind jeweils gleich, S4a = S4b = 0, S4e = S4f = 0 und werden somit weitergeleitet als erstes und drittes Ausgangssignal S41 = 0 und S43 = 0. Die ODER-Verknüpfung ergibt wieder S6 = 0, somit ist die Störung eliminiert.

Dies betrifft vor allem den AC-Betrieb. Für universelle Geräte, die sowohl AC- als auch DC-versorgt werden können, mit dann entsprechenden AC- oder DC-Eingängen, kann am Ausgang der Logikschaltung 19 noch ein steuerbarer Umschalter 18 zwischen den AC- und den DC-Betrieb vorgesehen sein. Dadurch wird am Ausgang S7 entweder direkt das Komparatorsignal S1 für den DC-Betrieb oder das Wechselspannungszustandssignal S6 für den AC-Betrieb zugeschaltet. Die Ansteuerung erfolgt durch eine in Fig. 5 bzw. Fig. 7 nicht näher gezeigte Schaltung vom Detektorsignal S2 oder von einem der Taktsignale S3a bis S3f. Im Fall der AC-Versorgung sind diese Signale impulsförmig, bei DC-Versorgung statisch. Die Impulse könnten z.B. ein retriggerbares Monoflop (monostabile Kippstufe) ansteuern und so zwischen AC (Ausgang aktiv) und DC (Ausgang inaktiv) unterscheiden.

Beipielsweise wird der Logikblock 19 in der Firmware eines Mikrocontrollers implementiert.

Die unterschiedlichen Verfahren werden tabellarisch in Figuren 12 bis 14 dargestellt, die verschiedene Verfahren zur Implementierung der Logikfunktion in der Firmware eines Mikrocontrollers angeben. Ein Zeitglied kann als Timer bezeichnet werden. Eine Unterbrechung kann auch als Interrupt bezeichnet werden.

Figur 12 zeigt eine Tabelle, die ein Verfahren zur Firmware-Implementierung einphasig angibt. Die Tabelle beschreibt das Verfahren zur Erfassung und Entstörung einphasiger Eingänge, vgl. Fig. 1A.

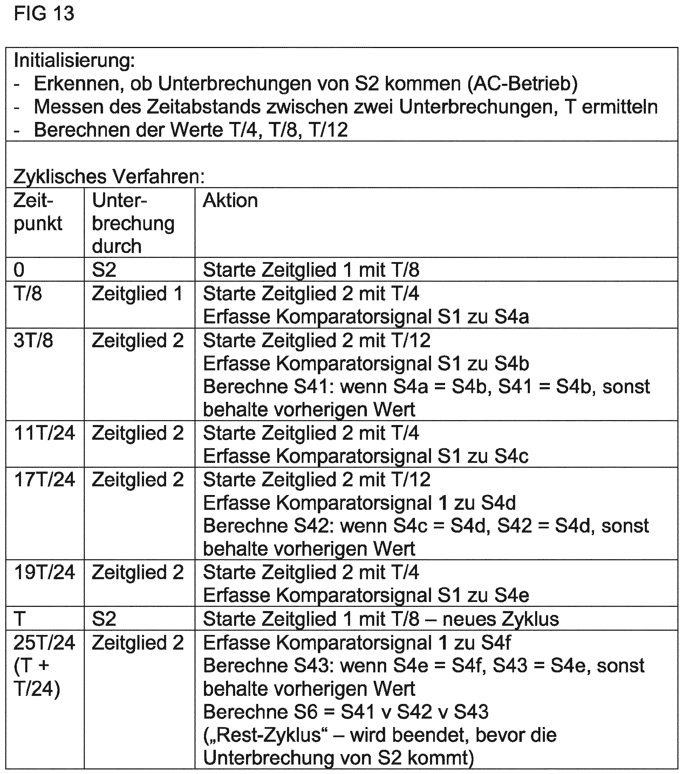

Figur 13 zeigt eine Tabelle, die ein Verfahren zur Firmware-Implementierung dreiphasig mit zwei Timern erläutert. Die Tabelle beschreibt das Verfahren zur Erfassung und Entstörung dreiphasiger Eingänge mit zwei Mikrocontroller-internen Timern, vgl. Fig. 5. Die zwei Timer könnten auch alternativ nacheinander bzw. beliebig verwendet werden, die einzige Einschränkung ist, dass die Zeit ab Zeitpunkt 0 und die letzte Zeit ab 19T/24 mit unterschiedlichen Timern zu implementieren wäre, denn sie laufen zum Teil gleichzeitig.

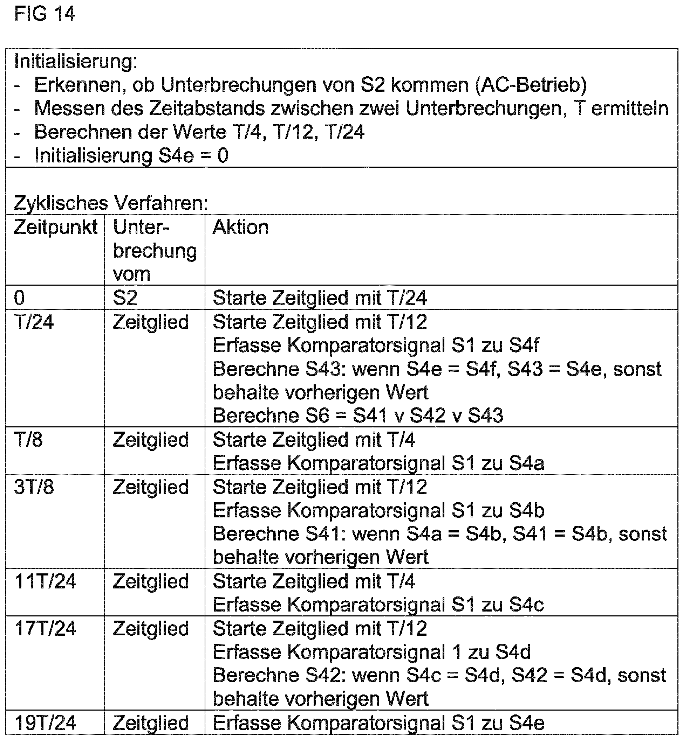

Figur 14 zeigt eine Tabelle, die ein Verfahren zur Firmware-Implementierung dreiphasig mit genau einem Timer angibt. Die Tabelle beschreibt das Verfahren zur Erfassung und Entstörung dreiphasiger Eingänge mit einem Mikrocontroller-internen Timer, vgl. Fig. 7.

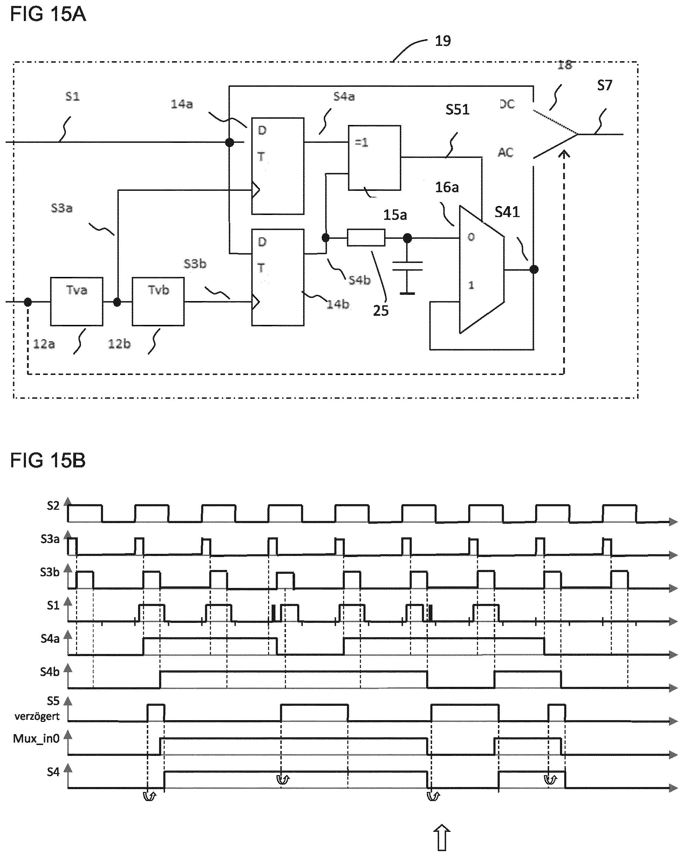

Figuren 15A bis 15C zeigen ein Beispiel eines Details der oben dargestellten Schaltungsanordnung und von Signalen der Schaltungsanordnung. Damit eine Hardwareschaltung wie in Fig. 1A gezeigt mit dem Multiplexer richtig funktioniert, kann noch eine zusätzliche Verzögerung (z.B. ein RC-Glied) zwischen dem Ausgang des zweiten Flip-Flops 14b, an dem das zweite Zustandssignal S4b bereitgestellt wird, und dem Eingang "0" des Multiplexers 16a vorgesehen werden. Ein

Verzögerungsglied 25 ist zwischen dem Ausgang des zweiten Flip-Flops 14b und dem Eingang "0" des Multiplexers 16a angeordnet. Das Verzögerungsglied 25 kann als Filter, z.B. als Tiefpass oder RC-Glied oder als hintereinandergeschaltete Inverter realisiert sein.

Grundsätzlich ist die richtige Funktion bei einem Signalwechsel dadurch sichergestellt, dass zum Eingang 0 des Multiplexers 16a das zweite Zustandssignal S4b und nicht das erste Zustandssignal S4a zugeführt wird. Ändert sich der Zustand des Komparatorsignals S1 (von 0 zu 1 oder von 1 zu 0), so schaltet erst das erste Zustandssignal S4a und erst nach T/4 auch das zweite Zustandssignal S4b um. Der Zustandswechsel vom ersten Zustandssignal S4a schaltet durch das erste Verarbeitungssignal S51 den Multiplexer 16a auf Eingang "1", während das zweite Zustandssignal S4b noch stabil auf dem alten Wert ist und zwar der gleiche wie das erste Ausgangssignal S41. Dadurch entstehen keine Probleme beim Umschalten, der alte Wert wird zunächst beibehalten. Nimmt nach T/4 auch das zweite Zustandssignal S4b den neuen Wert an, so schaltet der Multiplexer 16a auf Eingang "0" um und der neue Wert wird als erstes Ausgangssignal S41 weitergegeben.

Auch wenn eine Störung den Wert von S4a verfälscht, entstehen durch den beschriebenen Mechanismus keine Probleme, S41 bleibt beim alten Wert so wie S4b auch.

Ein Problem würde tatsächlich dann entstehen, wenn eine Störung den Wert von S4b verfälscht, S4a bleibt beim alten Wert. Weil S4a ≠ S4b würde der Multiplexer 16a zwar auf den Eingang "1" schalten, um den alten Wert beizubehalten, jedoch mit der vom XOR-Gatter 15a und der eigenen Umschaltzeit verursachten Verzögerung. In der Zeit aber würde der falsche Wert von S4b schon an S41 weitergegeben und beim Umschalten des Multiplexers 16a würde der neue, falsche Wert beibehalten und nicht der vorherige. Damit die Schaltung richtig funktioniert, ist eine Verzögerung des Signals S4b zum Eingang "0" des Multiplexers 16a sinnvoll, die größer ist als die des Umschaltsignals, das heißt des ersten Verarbeitungssignals S51. In der Praxis könnte die Schaltung z.B. so wie in Figur 15A realisiert sein. In der Praxis könnte für eine Hardware-Implementierung eine zusätzliche Verzögerung des Signals S4b zum Eingang "0" des Multiplexers 16a sinnvoll sein, um eine einwandfreie Umschaltfunktion sicher zu stellen.

Das hat für die Software-Implementierung keine Bedeutung. Eine Implementierung mittels Software kann ohne das Verzögerungsglied 25 erfolgen.

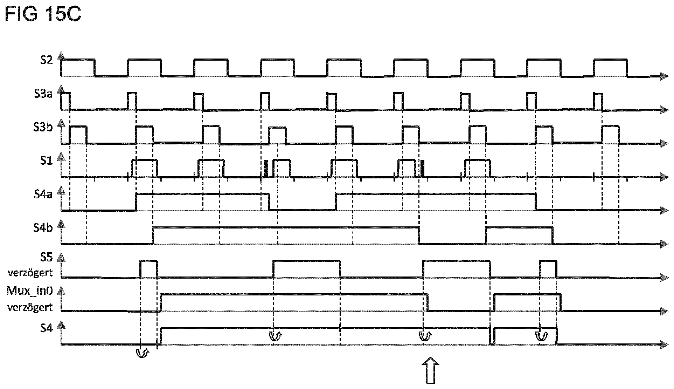

In Figuren 15B und 15C sind zur Erklärung der Funktion zwei Diagramme für den Fall ohne und den Fall mit Verzögerung des zweiten Zustandssignals S4b zum Multiplexer 16a gezeigt.

11

Figur 15B erläutert ein Funktionsdiagramm ohne Verzögerung des zweiten Zustandssignals S4b. Das zweite Zustandssignal S5 wird durch das XOR-Gatter 15a verzögert (hier übertrieben dargestellt). Die Störung des zweiten Zustandssignals S4b wird nicht eliminiert, weil das gestörte zweite Zustandssignal S4b am Multiplexer-Eingang "0" schneller ankommt als der Multiplexer 16a umschaltet.

Figur 15C erläutert ein Funktionsdiagramm mit Verzögerung des zweiten Zustandssignals S4b. Das erste Verarbeitungssignal S51 wird durch das XOR-Gatter 15a verzögert, aber das gestörte zweite Zustandssignal S4b wird noch länger zum Multiplexer-Eingang "0" verzögert (hier übertrieben dargestellt). Die Störung des zweiten Zustandssignals S4b wird eliminiert. Wegen der Verzögerung des zweiten Zustandssignals S4b entsteht am "Ende der Störung" doch noch ein kleiner Wischer Richtung 0. Die Verzögerungen sind aber in Wirklichkeit sehr gering (im 10 ns bis 100 ns Bereich) und der Wischer wird problemlos mit einer zusätzlichen Filterung des ersten Ausgangssignals S41 weggebügelt, d.h. eliminiert.

Es wird auf die Dokumente EP0935758B1, DE102017116534A1 und DE102017127070.1 verwiesen (z.B. zur Erläuterung von Details der Schaltungsanordnung und der Verfahren).

Die in den Figuren 1A bis 15C dargestellten Ausführungsformen stellen wie angegeben exemplarische Ausführungsformen der verbesserten Schaltungsanordnung und des Verfahrens dar, stellen daher keine vollständige Liste aller Ausführungsformen der verbesserten Schaltungsanordnung dar. Die tatsächlichen Konfigurationen der Schaltungsanordnung können von den Ausführungsformen abweichen, die z.B. in Bezug auf Schaltungsteile, Verfahrensschritte oder Schaltungsparameter wie Verzögerungszeiten dargestellt werden.

**Patentansprüche**

1. Schaltungsanordnung zur Überwachung eines wechselspannungsförmigen Signals (Ik), umfassend:

- einen Komparator (8), dem an einem ersten Komparatoreingang das wechselspannungsförmige Signal (Ik) oder ein daraus gewonnenes Signal zuführbar ist und der eingerichtet ist, an einem Komparatorausgang ein Komparatorsignal (S1) in Abhängigkeit von einem Vergleich des wechselspannungsförmigen Signals (Ik) oder des daraus gewonnenen Signals mit einem definierten Schwellenwert (Uth) abzugeben,
- einen Nulldurchgangsdetektor (10), dem an einem Überwachungseingang ein Referenzsignal oder ein daraus gewonnenes Signal zuführbar ist und der eingerichtet ist, an einem Ausgang des Nulldurchgangsdetektors (10) ein Detektorsignal (S2) zu erzeugen, und
- eine Logikschaltung (19),
wobei das Referenzsignal wechselspannungsförmig ist und das Referenzsignal und das wechselspannungsförmige Signal (Ik) frequenzgleich sind,
wobei die Logikschaltung (19) umfasst:

- ein dem Nulldurchgangsdetektor (10) nachgeschaltetes erstes Zeitglied (12a) zur Erzeugung eines ersten Taktsignals (S3a) in Abhängigkeit vom Detektorsignal (S2),
- ein dem Nulldurchgangsdetektor (10) nachgeschaltetes zweites Zeitglied (12b) zur Erzeugung eines zweiten Taktsignals (S3b) in Abhängigkeit vom Detektorsignal (S2) oder in Abhängigkeit vom ersten Taktsignal (S3a),
- ein erstes und ein zweites Flip-Flop (14a, 14b) und
- ein Exklusiv-Oder-Gatter (15a),

wobei ein Ausgang des Komparators (8) mit einem Dateneingang (D) des ersten Flip-Flops (14a) und des zweiten Flip-Flops (14b) gekoppelt ist,
wobei ein Ausgang des ersten Zeitglieds (12a) mit einem Takteingang des ersten Flip-Flops (14a) gekoppelt ist und ein Ausgang des zweiten Zeitglieds (12b) mit einem Takteingang des zweiten Flip-Flops (14b) gekoppelt ist,
wobei ein Ausgang des ersten Flip-Flops (14a) und ein Ausgang des zweiten Flip-Flops (14b) mit Eingängen des Exklusiv-Oder-Gatters (15a) gekoppelt sind,
wobei das Exklusiv-Oder-Gatter (15a) eingerichtet ist, ein erstes Verarbeitungssignal (S51) zu generieren,
wobei die Logikschaltung (19) eingerichtet ist, das Komparatorsignal (S1) an mindestens zwei vorgegebenen Zeitpunkten abzutasten und das erste Verarbeitungssignal (S51) mit einem ersten Wert zu generieren, wenn an zwei bestimmten Zeitpunkten der mindestens zwei vorgegebenen Zeitpunkte das Komparatorsignal (S1) unterschiedliche Werte aufweist, und mit einem zweiten Wert zu generieren, wenn an den zwei bestimmten Zeitpunkten das Komparatorsignal (S1) denselben Wert aufweist, und
wobei die zwei bestimmten Zeitpunkte der mindestens zwei vorgegebenen Zeitpunkte bei folgenden Werten

liegen:

$$T/4 - \Delta t \text{ und } T/4 + \Delta t,$$

wobei T eine Periodendauer des zu überwachenden wechselspannungsförmigen Signals (Ik) und Δt eine Zeitdauer kleiner T/4 ist.

2. Schaltungsanordnung nach Anspruch 1,
wobei die Logikschaltung (19) eingerichtet ist,

- bei dem zweiten Wert des ersten Verarbeitungssignals (S51) ein erstes Ausgangssignal (S41) zu generieren, das den Wert des an den zwei bestimmten Zeitpunkten abgetasteten Wert des Komparatorsignals (S1) hat, und
- bei dem ersten Wert des ersten Verarbeitungssignals (S51) den vorhergehenden Wert des ersten Ausgangssignals (S41) beizubehalten.

3. Schaltungsanordnung nach Anspruch 1 oder 2,

wobei die Logikschaltung (19) eingerichtet ist, ein zweites Verarbeitungssignal (S52) mit einem ersten Wert zu generieren, wenn an zwei weiteren bestimmten Zeitpunkten der mindestens zwei vorgegebenen Zeitpunkte das Komparatorsignal (S1) unterschiedliche Werte aufweist, und mit einem zweiten Wert zu generieren, wenn an den zwei weiteren bestimmten Zeitpunkten das Komparatorsignal (S1) denselben Wert aufweist, und
wobei die Logikschaltung (19) eingerichtet ist, ein drittes Verarbeitungssignal (S53) mit einem ersten Wert zu generieren, wenn an zwei zusätzlichen bestimmten Zeitpunkten der mindestens zwei vorgegebenen Zeitpunkte das Komparatorsignal (S1) unterschiedliche Werte aufweist, und mit einem zweiten Wert zu generieren, wenn an den zwei zusätzlichen bestimmten Zeitpunkten das Komparatorsignal (S1) denselben Wert aufweist.

4. Schaltungsanordnung nach Anspruch 3,

wobei die Logikschaltung (19) eingerichtet ist,

- bei dem zweiten Wert des zweiten Verarbeitungssignals (S52) ein zweiten Ausgangssignal (S42) zu generieren, das den Wert des an den zwei weiteren bestimmten Zeitpunkten abgetasteten Wert des Komparatorsignals (S1) hat, und
- bei dem ersten Wert des zweiten Verarbeitungssignals (S52) den vorhergehenden Wert des zweiten Ausgangssignals (S42) beizubehalten,
- bei dem zweiten Wert des dritten Verarbeitungssignals (S53) ein drittes Ausgangssignal (S43) zu generieren, das den Wert des an den zwei zusätzlichen bestimmten Zeitpunkten abgetasteten Wert des Komparatorsignals (S1) hat, und
- bei dem ersten Wert des dritten Verarbeitungssignals (S53) den vorhergehenden Wert des dritten Ausgangssignals (S43) beizubehalten, und

ein Wechselspannungszustandssignal (S6) durch ODER-Verknüpfung des ersten, des zweiten und des dritten Ausgangssignals (S41, S42, S43) zu generieren.

5. Schaltungsanordnung nach einem der Ansprüche 1 bis 4, wobei die Logikschaltung (19) als Mikrocontroller oder Mikroprozessor realisiert ist.

6. Schaltungsanordnung nach einem der Ansprüche 1 bis 5, wobei das zweite Zeitglied (12b) dem ersten Zeitglied (12a) nachgeschaltet ist und eingerichtet ist, durch das erste Taktsignal (S3a) zur Erzeugung des zweiten Taktsignals (S3b) getriggert zu werden.

7. Schaltungsanordnung nach einem der Ansprüche 1 bis 6, wobei die Logikschaltung (19) einen Multiplexer (16a) umfasst und der Multiplexer (16a) aufweist:

- einen ersten Eingang, der mit dem Ausgang des ersten oder des zweiten Flip-Flops (14a, 14b) gekoppelt ist,
- einen zweiten Eingang,
- einen Steuereingang, der mit einem Ausgang des Exklusiv-Oder-Gatters (15a) gekoppelt ist, und

- einen Ausgang, der mit dem zweiten Eingang gekoppelt ist und eingerichtet ist, das erste Ausgangssignal (S41) abzugeben.

8. Schaltungsanordnung nach Anspruch 7, wobei der Multiplexer (16a), das Exklusiv-Oder-Gatter (15a), die Flip-Flops (14a, 14b) und die Zeitglieder (12a, 12b) durch Software innerhalb eines Mikrocontrollers oder Mikroprozessors realisiert sind.

9. Schaltungsanordnung nach einem der Ansprüche 1 bis 8, wobei die zwei bestimmten Zeitpunkte T/8 und T·3/8 sind.

10. Verfahren zur Überwachung eines wechselspannungsförmigen Signals (Ik), umfassend:

- Erfassen des wechselspannungsförmigen Signals (Ik),
- Erzeugen eines Komparatorsignals (S1) durch einen Komparator (8) in Abhängigkeit von einem Vergleich des wechselspannungsförmigen Signals (Ik) oder des daraus gewonnenen Signals mit einem definierten Schwellenwert (Uth),
- Erzeugen eines Detektorsignal (S2) durch einen Nulldurchgangsdetektors (10), dem ein Referenzsignal oder ein daraus gewonnenes Signal zugeführt wird, und
- Abtasten des Komparatorsignals (S1) an mindestens zwei vorgegebenen Zeitpunkten und Generieren eines ersten Verarbeitungssignals (S51) mit einem ersten Wert, wenn an zwei bestimmten Zeitpunkten der mindestens zwei vorgegebenen Zeitpunkte das Komparatorsignal (S1) unterschiedliche Werte aufweist, und mit einem zweiten Wert, wenn an den zwei bestimmten Zeitpunkten das Komparatorsignal (S1) denselben Wert aufweist, wobei das Referenzsignal wechselspannungsförmig ist und das Referenzsignal und das wechselspannungsförmige Signal (Ik) frequenzgleich sind, wobei die zwei bestimmten Zeitpunkte der mindestens zwei vorgegebenen Zeitpunkte bei folgenden Werten liegen:

$$T/4 - \Delta t \text{ und } T/4 + \Delta t,$$

wobei T eine Periodendauer des zu überwachenden wechselspannungsförmigen Signals (Ik) und $\Delta t$ eine Zeitdauer kleiner T/4 ist, wobei eine Logikschaltung (19) umfasst:

- ein dem Nulldurchgangsdetektor (10) nachgeschaltetes erstes Zeitglied (12a) zur Erzeugung eines ersten Taktsignals (S3a) in Abhängigkeit vom Detektorsignal (S2),
- ein dem Nulldurchgangsdetektor (10) nachgeschaltetes zweites Zeitglied (12b) zur Erzeugung eines zweiten Taktsignals (S3b) in Abhängigkeit vom Detektorsignal (S2) oder in Abhängigkeit vom ersten Taktsignal (S3a),
- ein erstes und ein zweites Flip-Flop (14a, 14b) und
- ein Exklusiv-Oder-Gatter (15a),

wobei ein Ausgang des Komparators (8) mit einem Dateneingang (D) des ersten Flip-Flops (14a) und des zweiten Flip-Flops (14b) gekoppelt ist, wobei ein Ausgang des ersten Zeitglieds (12a) mit einem Takteingang des ersten Flip-Flops (14a) gekoppelt ist und ein Ausgang des zweiten Zeitglieds (12b) mit einem Takteingang des zweiten Flip-Flops (14b) gekoppelt ist, wobei ein Ausgang des ersten Flip-Flops (14a) und ein Ausgang des zweiten Flip-Flops (14b) mit Eingängen des Exklusiv-Oder-Gatters (15a) gekoppelt sind, und wobei das Exklusiv-Oder-Gatter (15a) das erste Verarbeitungssignal (S51) generiert.

**Claims**

1. A circuit arrangement for monitoring an alternating voltage signal (Ik), comprising:

- a comparator (8) to which, at a first comparator input, the alternating voltage signal (Ik) or a signal obtained therefrom can be fed and which is configured to output, at a comparator output, a comparator signal (S1) on the basis of a comparison of the alternating voltage signal (Ik) or the signal obtained therefrom with a defined threshold value (Uth),
- a zero crossing detector (10) to which, at a monitoring input, a reference signal or a signal obtained therefrom can be fed and which is configured to generate a detector signal (S2) at an output of the zero crossing detector (10), and
- a logic circuit (19),

wherein the reference signal is an alternating voltage signal, and the reference signal and the alternating voltage signal (Ik) are of the same frequency,
wherein the logic circuit (19) comprises:

- a first timing element (12a) connected downstream of the zero crossing detector (10) for generating a first clock signal (S3a) on the basis of the detector signal (S2),
- a second timing element (12b) connected downstream of the zero crossing detector (10) for generating a second clock signal (S3b) on the basis of the detector signal (S2) or on the basis of the first clock signal (S3a),
- a first and a second flip-flop (14a, 14b) and
- an exclusive OR gate (15a),

wherein an output of the comparator (8) is coupled to a data input (D) of the first flip-flop (14a) and of the second flip-flop (14b),
wherein an output of the first timing element (12a) is coupled to a clock input of the first flip-flop (14a) and an output of the second timing element (12b) is coupled to a clock input of the second flip-flop (14b),
wherein an output of the first flip-flop (14a) and an output of the second flip-flop (14b) are coupled to inputs of the exclusive OR gate (15a),
wherein the exclusive OR gate (15a) is configured to generate a first processing signal (S51),
wherein the logic circuit (19) is configured to sample the comparator signal (S1) at at least two predefined points of time and to generate the first processing signal (S51) with a first value if the comparator signal (S1) has different values at two particular points of time of the at least two predefined points of time, and to generate said first processing signal with a second value if the comparator signal (S1) has the same value at the two particular points of time, and
wherein the two particular points of time of the at least two predefined points of time are at the following values:

$$T/4 - \Delta t \text{ and } T/4 + \Delta t,$$

where T is a period duration of the alternating voltage signal (Ik) to be monitored and $\Delta t$ is a time period less than T/4.

2. The circuit arrangement according to claim 1,
wherein the logic circuit (19) is configured

- at the second value of the first processing signal (S51), to generate a first output signal (S41) which has the value of the value of the comparator signal (S1) sampled at the two particular points of time, and
- at the first value of the first processing signal (S51), to maintain the previous value of the first output signal (S41).

3. The circuit arrangement according to claim 1 or 2,

wherein the logic circuit (19) is configured to generate a second processing signal (S52) with a first value if the comparator signal (S1) has different values at two further particular points of time of the at least two predefined points of time, and to generate said second processing signal with a second value if the comparator signal (S1) has the same value at the two further particular points of time, and
wherein the logic circuit (19) is configured to generate a third processing signal (S53) with a first value if the comparator signal (S1) has different values at two additional particular points of time of the at least two predefined points of time, and to generate said third processing signal with a second value if the comparator signal (S1) has the same value at the two additional particular points of time.

4. The circuit arrangement according to claim 3,
wherein the logic circuit (19) is configured

- at the second value of the second processing signal (S52), to generate a second output signal (S42) which has the value of the value of the comparator signal (S1) sampled at the two further particular points of time, and
- at the first value of the second processing signal (S52), to maintain the previous value of the second output signal (S42),
- at the second value of the third processing signal (S53), to generate a third output signal (S43) which has the value of the value of the comparator signal (S1) sampled at the two additional particular points of time, and
- at the first value of the third processing signal (S53), to maintain the previous value of the third output signal (S43), and to generate an alternating voltage status signal (S6) by OR linking the first, the second and the third output signal (S41, S42, S43).

5. The circuit arrangement according to any of claims 1 to 4, wherein the logic circuit (19) is implemented as a microcontroller or microprocessor.

6. The circuit arrangement according to any of claims 1 to 5, wherein the second timing element (12b) is connected downstream of the first timing element (12a) and is configured to be triggered by the first clock signal (S3a) in order to generate the second clock signal (S3b).

7. The circuit arrangement according to any of claims 1 to 6, wherein the logic circuit (19) comprises a multiplexer (16a) and the multiplexer (16a) comprises:

   - a first input which is coupled to the output of the first or the second flip-flop (14a, 14b),
   - a second input,
   - a control input which is coupled to an output of the exclusive OR gate (15a), and
   - an output which is coupled to the second input and is configured to output the first output signal (S41).

8. The circuit arrangement according to claim 7, wherein the multiplexer (16a), the exclusive OR gate (15a), the flip-flops (14a, 14b) and the timing elements (12a, 12b) are implemented by software within a microcontroller or microprocessor.

9. The circuit arrangement according to any of claims 1 to 8, wherein the two particular points of time are T/8 and T·3/8.

10. A method for monitoring an alternating voltage signal (Ik), comprising:

    - capturing the alternating voltage signal (Ik),
    - generating a comparator signal (S1) by means of a comparator (8) on the basis of a comparison of the alternating voltage signal (Ik) or the signal obtained therefrom with a defined threshold value (Uth),
    - generating a detector signal (S2) by means of a zero crossing detector (10) to which a reference signal or a signal obtained therefrom is fed, and
    - sampling the comparator signal (S1) at at least two predefined points of time and generating a first processing signal (S51) with a first value if the comparator signal (S1) has different values at two particular points of time of the at least two predefined points of time, and generating said first processing signal with a second value if the comparator signal (S1) has the same value at the two particular points of time,

      wherein the reference signal is an alternating voltage signal, and the reference signal and the alternating voltage signal (Ik) are of the same frequency,
      wherein the two particular points of time of the at least two predefined points of time are at the following values:

$$T/4 - \Delta t \text{ and } T/4 + \Delta t,$$

      where T is a period duration of the alternating voltage signal (Ik) to be monitored and $\Delta t$ is a time period less than T/4,
      wherein a logic circuit (19) comprises:

      - a first timing element (12a) connected downstream of the zero crossing detector (10) for generating a first clock signal (S3a) on the basis of the detector signal (S2),
      - a second timing element (12b) connected downstream of the zero crossing detector (10) for generating a second clock signal (S3b) on the basis of the detector signal (S2) or on the basis of the first clock signal (S3a),

- a first and a second flip-flop (14a, 14b) and
- an exclusive OR gate (15a),

wherein an output of the comparator (8) is coupled to a data input (D) of the first flip-flop (14a) and the second flip-flop (14b),
wherein an output of the first timing element (12a) is coupled to a clock input of the first flip-flop (14a) and an output of the second timing element (12b) is coupled to a clock input of the second flip-flop (14b),
wherein an output of the first flip-flop (14a) and an output of the second flip-flop (14b) are coupled to inputs of the exclusive OR gate (15a), and
wherein the exclusive OR gate (15a) generates the first processing signal (S51).

**Revendications**

1. Système de circuit destiné à surveiller un signal (Ik) sous forme de tension alternative, comprenant :

- un comparateur (8), auquel peut être appliqué, au niveau d'une première entrée de comparateur, le signal (Ik) sous forme de tension alternative ou un signal obtenu à partir de celui-ci et qui est conçu pour émettre, au niveau d'une sortie de comparateur, un signal de comparateur (S1) en fonction d'une comparaison du signal (Ik) sous forme de tension alternative ou du signal obtenu à partir de celui-ci à une valeur seuil (Uth) définie,
- un détecteur de passage par zéro (10), auquel peut être appliqué, au niveau d'une entrée de surveillance, un signal de référence ou un signal obtenu à partir de celui-ci et qui est conçu pour générer, au niveau d'une sortie du détecteur de passage par zéro (10), un signal de détecteur (S2) et
- un circuit logique (19),

le signal de référence étant sous forme de tension alternative et le signal de référence et le signal (Ik) sous forme de tension alternative étant de même fréquence,
le circuit logique (19) comprenant :

- un premier temporisateur (12a) monté en aval du détecteur de passage par zéro (10) et destiné à générer un premier signal d'horloge (S3a) en fonction du signal de détecteur (S2),
- un deuxième temporisateur (12b) monté en aval du détecteur de passage par zéro (10) et destiné à générer un deuxième signal d'horloge (S3b) en fonction du signal de détecteur (S2) ou en fonction du premier signal d'horloge (S3a),
- une première et une deuxième bascule bistable (14a, 14b) et
- une porte OU exclusive (15a),

une sortie du comparateur (8) étant couplée à une entrée de données (D) de la première bascule bistable (14a) et de la deuxième bascule bistable (14b),
une sortie du premier temporisateur (12a) étant couplée à une entrée d'horloge de la première bascule bistable (14a) et une sortie du deuxième temporisateur (12b) étant couplée à une entrée d'horloge de la deuxième bascule bistable (14b),
une sortie de la première bascule bistable (14a) et une sortie de la deuxième bascule bistable (14b) étant couplée à des entrées de la porte OU exclusive (15a),
la porte OU exclusive (15a) étant conçue pour générer un premier signal de transformation (S51),
le circuit logique (19) étant conçu pour échantillonner le signal de comparateur (S1) en au moins deux moments spécifiés et générer le premier signal de transformation (S51) avec une première valeur lorsque, en au moins deux moments déterminés des au moins deux moments spécifiés, le signal de comparateur (S1) présente des valeurs différentes et avec une deuxième valeur lorsque, en les deux moments déterminés, le signal de comparateur (S1) présente la même valeur et
les deux moments déterminés des au moins deux moments spécifiés se situant aux valeurs suivantes :

$$T/4 - \Delta t \ \text{et} \ T/4 + \Delta t,$$

T représentant une durée de période du signal (Ik) sous forme de tension alternative à surveiller et $\Delta t$ représentant une durée inférieure à T/4.

**EP 3 948 311 B1**

**2.** Système de circuit selon la revendication 1,
le circuit logique (19) étant conçu pour

- générer, à la deuxième valeur du premier signal de transformation (S51), un premier signal de sortie (S41) qui présente la valeur de la valeur du signal de comparateur (S1) échantillonné aux deux moments déterminés et
- conserver, à la première valeur du premier signal de transformation (S51), la valeur antérieure du premier signal de sortie (S41).

**3.** Système de circuit selon la revendication 1 ou 2,

le circuit logique (19) étant conçu pour générer un deuxième signal de transformation (S52) avec une première valeur lorsque, en deux autres moments déterminés des au moins deux moments spécifiés, le signal de comparateur (S1) présente des valeurs différentes et avec une deuxième valeur lorsque, en les deux autres moments déterminés, le signal de comparateur (S1) présente la même valeur et
le circuit logique (19) étant conçu pour générer un troisième signal de transformation (S53) avec une première valeur lorsque, en deux moments déterminés supplémentaires des au moins deux moments spécifiés, le signal de comparateur (S1) présente des valeurs différentes et avec une deuxième valeur lorsque, en les deux moments déterminés supplémentaires, le signal de comparateur (S1) présente la même valeur.

**4.** Système de circuit selon la revendication 3,
le circuit logique (19) étant conçu pour

- générer, à la deuxième valeur du deuxième signal de transformation (S52), un deuxième signal de sortie (S42) qui présente la valeur de la valeur du signal de comparateur (S1) échantillonné en les deux autres moments déterminés et
- conserver, à la première valeur du deuxième signal de transformation (S52), la valeur antérieure du deuxième signal de sortie (S42),
- générer, à la deuxième valeur du troisième signal de transformation (S53), un troisième signal de sortie (S43) qui présente la valeur de la valeur du signal de comparateur (S1) échantillonné en les deux moments déterminés supplémentaires et
- conserver, à la première valeur du troisième signal de transformation (S53), la valeur antérieure du troisième signal de sortie (S43) et générer un signal d'état de tension alternative (S6) par liaison OU du premier, du deuxième et du troisième signal de sortie (S41, S42, S43).

**5.** Système de circuit selon l'une des revendications 1 à 4, le circuit logique (19) étant réalisé comme un microcontrôleur ou un microprocesseur.

**6.** Système de circuit selon l'une des revendications 1 à 5, le deuxième temporisateur (12b) étant monté en aval du premier temporisateur (12a) et étant conçu pour être déclenché par le premier signal d'horloge (S3a) afin de générer le deuxième signal d'horloge (S3b).

**7.** Système de circuit selon l'une des revendications 1 à 6, le circuit logique (19) comprenant un multiplexeur (16a) et le multiplexeur (16a) présentant :

- une première entrée, qui est couplée à la sortie de la première ou de la deuxième bascule bistable (14a, 14b),
- une deuxième entrée,
- une entrée de commande, qui est couplée à une sortie de la porte OU exclusive (15a) et
- une sortie, qui est couplée à la deuxième entrée et qui est conçue pour émettre le premier signal de sortie (S41).

**8.** Système de circuit selon la revendication 7, le multiplexeur (16a), la porte OU exclusive (15a), les bascules bistables (14a, 14b) et les temporisateurs (12a, 12b) étant réalisés par des logiciels au sein d'un microcontrôleur ou d'un microprocesseur.

**9.** Système de circuit selon l'une des revendications 1 à 8, les deux moments déterminés étant T/8 et T·3/8.

**10.** Procédé destiné à surveiller un signal (Ik) sous forme de tension alternative, comprenant :

- la détection du signal (Ik) en forme de tension alternative,

18

- la génération d'un signal de comparateur (S1) par un comparateur (8) en fonction d'une comparaison du signal (Ik) en forme de tension alternative ou du signal obtenu à partir de celui-ci à une valeur seuil définie (Uth),
- la génération d'un signal de détecteur (S2) par un détecteur de passage par zéro (10), auquel un signal de référence ou un signal obtenu à partir de celui-ci est appliqué et
- l'échantillonnage du signal de comparateur (S1) en au moins deux moments spécifiés et génération d'un premier signal de transformation (S51) avec une première valeur lorsque, en deux moments déterminés des au moins deux moments spécifiés, le signal de comparateur (S1) présente des valeurs différentes et avec une deuxième valeur lorsque, en les deux moments déterminés, le signal de comparateur (S1) présente la même valeur,

le signal de référence étant sous forme de tension alternative et le signal de référence et le signal (Ik) sous forme de tension alternative étant de même fréquence,
les deux moments déterminés des au moins deux moments spécifiés se situant aux valeurs suivantes :

$$T/4 - \Delta t \text{ et } T/4 + \Delta t,$$

T représentant une durée de période du signal (Ik) sous forme de tension alternative à surveiller et $\Delta t$ représentant une durée inférieure à T/4,
un circuit logique (19) comprenant :

- un premier temporisateur (12a) monté en aval du détecteur de passage par zéro (10) et destiné à générer un premier signal d'horloge (S3a) en fonction du signal de détecteur (S2),
- un deuxième temporisateur (12b) monté en aval du détecteur de passage par zéro (10) et destiné à générer un deuxième signal d'horloge (S3b) en fonction du signal de détecteur (S2) ou en fonction du premier signal d'horloge (S3a),
- une première et une deuxième bascule bistable (14a, 14b) et
- une porte OU exclusive (15a),

une sortie du comparateur (8) étant couplée à une entrée de données (D) de la première bascule bistable (14a) et de la deuxième bascule bistable (14b),
une sortie du premier temporisateur (12a) étant couplée à une entrée d'horloge de la première bascule bistable (14a) et une sortie du deuxième temporisateur (12b) étant couplée à une entrée d'horloge de la deuxième bascule bistable (14b),
une sortie de la première bascule bistable (14a) et une sortie de la deuxième bascule bistable (14b) étant couplées à des entrées de la porte OU exclusive (15a) et
la porte OU exclusive (15a) générant le premier signal de transformation (S51).

## FIG 1A

## FIG 1B

## FIG 1C

| Eingang 1 | Eingang 2 | Ausgang |
|:---------:|:---------:|:-------:|
| 0 | 0 | 0 |
| 1 | 0 | 1 |
| 0 | 1 | 1 |
| 1 | 1 | 0 |

## FIG 2

FIG 3

FIG 4

FIG 5

FIG 6

FIG 7

FIG 8

| | | |
|---|---|---|
| L1: | T/8    3T/8 | T+T/8   T+3T/8 |
| L2: | 11T/24   17T/24 | T+11T/24   T+17T/24 |
| L3: | 19T/24   25T/24 | T+19T/24   T+25T/24 |

S4a,b: 1        1                          0        1

S4c,d:        0        0                          0        0

S4e,f:   =           0        0      ≠           0        0

S41      1      =                verworfen   =
                                 bleibt 1
S42             0      =                       0      =
S43                   0                              0

S6 = 1 v 0 v 0 = 1                S6 = 1 v 0 v 0 = 1

FIG 9

FIG 10

## FIG 11

L1: T/8    3T/8              T+T/8   T+3T/8
L2:        11T/24  17T/24            T+11T/24  T+17T/24
L3:                19T/24  25T/24                        T+19T/24  T+25T/24
S4a,b: 0      0                      0        0
S4c,d:          0      0                  0        1
S4e,f:              0      0                          0        0

S41     0                   0
S42         0                   verworfen
S43             0               bleibt 0            0

S6 = 0 v 0 v 0 = 0                S6 = 0 v 0 v 0 = 0

## FIG 12

| Initialisierung: | | |
|---|---|---|
| - Erkennen, ob Unterbrechungen von S2 kommen (AC-Betrieb) | | |
| - Messen des Zeitabstands zwischen zwei Unterbrechungen, T ermitteln | | |
| - Berechnen der Werte T/4, T/8 | | |
| **Zyklisches Verfahren:** | | |
| Zeitpunkt | Unterbrechung durch | Aktion |
| 0 | S2 | Starte Zeitglied mit T/8 |
| T/8 | Zeitglied | Starte Zeitglied mit T/4<br>Erfasse Komparatorsignal S1 zu S4a |
| 3T/8 | Zeitglied | Erfasse Komparatorsignal S1 zu S4b<br>Berechne S4: wenn S3a = S3b, S41 = S3b,<br>sonst behalte vorherigen Wert |

FIG 13

| Initialisierung:<br>- Erkennen, ob Unterbrechungen von S2 kommen (AC-Betrieb)<br>- Messen des Zeitabstands zwischen zwei Unterbrechungen, T ermitteln<br>- Berechnen der Werte T/4, T/8, T/12 | | |
|---|---|---|
| Zyklisches Verfahren: | | |
| Zeit-punkt | Unter-brechung durch | Aktion |
| 0 | S2 | Starte Zeitglied 1 mit T/8 |
| T/8 | Zeitglied 1 | Starte Zeitglied 2 mit T/4<br>Erfasse Komparatorsignal S1 zu S4a |
| 3T/8 | Zeitglied 2 | Starte Zeitglied 2 mit T/12<br>Erfasse Komparatorsignal S1 zu S4b<br>Berechne S41: wenn S4a = S4b, S41 = S4b, sonst behalte vorherigen Wert |
| 11T/24 | Zeitglied 2 | Starte Zeitglied 2 mit T/4<br>Erfasse Komparatorsignal S1 zu S4c |
| 17T/24 | Zeitglied 2 | Starte Zeitglied 2 mit T/12<br>Erfasse Komparatorsignal 1 zu S4d<br>Berechne S42: wenn S4c = S4d, S42 = S4d, sonst behalte vorherigen Wert |
| 19T/24 | Zeitglied 2 | Starte Zeitglied 2 mit T/4<br>Erfasse Komparatorsignal S1 zu S4e |
| T | S2 | Starte Zeitglied 1 mit T/8 – neues Zyklus |
| 25T/24 (T + T/24) | Zeitglied 2 | Erfasse Komparatorsignal 1 zu S4f<br>Berechne S43: wenn S4e = S4f, S43 = S4e, sonst behalte vorherigen Wert<br>Berechne S6 = S41 v S42 v S43<br>(„Rest-Zyklus" – wird beendet, bevor die Unterbrechung von S2 kommt) |

FIG 14

| Initialisierung: |
|---|
| - Erkennen, ob Unterbrechungen von S2 kommen (AC-Betrieb) |
| - Messen des Zeitabstands zwischen zwei Unterbrechungen, T ermitteln |
| - Berechnen der Werte T/4, T/12, T/24 |
| - Initialisierung S4e = 0 |

| Zyklisches Verfahren: | | |
|---|---|---|
| Zeitpunkt | Unter-brechung vom | Aktion |
| 0 | S2 | Starte Zeitglied mit T/24 |
| T/24 | Zeitglied | Starte Zeitglied mit T/12<br>Erfasse Komparatorsignal S1 zu S4f<br>Berechne S43: wenn S4e = S4f, S43 = S4e, sonst behalte vorherigen Wert<br>Berechne S6 = S41 v S42 v S43 |
| T/8 | Zeitglied | Starte Zeitglied mit T/4<br>Erfasse Komparatorsignal S1 zu S4a |
| 3T/8 | Zeitglied | Starte Zeitglied mit T/12<br>Erfasse Komparatorsignal S1 zu S4b<br>Berechne S41: wenn S4a = S4b, S41 = S4b, sonst behalte vorherigen Wert |
| 11T/24 | Zeitglied | Starte Zeitglied mit T/4<br>Erfasse Komparatorsignal S1 zu S4c |
| 17T/24 | Zeitglied | Starte Zeitglied mit T/12<br>Erfasse Komparatorsignal 1 zu S4d<br>Berechne S42: wenn S4c = S4d, S42 = S4d, sonst behalte vorherigen Wert |
| 19T/24 | Zeitglied | Erfasse Komparatorsignal S1 zu S4e |

## FIG 15A

## FIG 15B

FIG 15C

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 0935758 B1
- DE 102017116534 A1
- US 3611162 A
- US 6255864 B1
- DE 102017127070